(19) Europäisches Patentamt
European Patent Office
Office européen des brevets

(11) EP 1 505 402 B1

(12) **EUROPÄISCHE PATENTSCHRIFT**

(45) Veröffentlichungstag und Bekanntmachung des Hinweises auf die Patenterteilung:
**05.09.2007 Patentblatt 2007/36**

(51) Int Cl.:
***G01R 31/36*** *(2006.01)*

(21) Anmeldenummer: **04014617.7**

(22) Anmeldetag: **22.06.2004**

(54) **Verfahren zur Vorhersage von elektrischen Eigenschaften einer elektrochemischen Speicherbatterie**

Method for predicting electric properties of an electrochemical storage-battery

Procédé pour la prédiction des charactéristiques électriques d'une batterie de stockage électrochimique

(84) Benannte Vertragsstaaten:
**AT BE BG CH CY CZ DE DK EE ES FI FR GB GR HU IE IT LI LU MC NL PL PT RO SE SI SK TR**

(30) Priorität: **06.08.2003 DE 10335930**

(43) Veröffentlichungstag der Anmeldung:
**09.02.2005 Patentblatt 2005/06**

(73) Patentinhaber: **VB Autobatterie GmbH & Co. KGaA**
**30419 Hannover (DE)**

(72) Erfinder: **Meissner, Eberhard, Dr.**
**31515 Wunstorf (DE)**

(74) Vertreter: **Gerstein, Hans Joachim et al**
**Gramm, Lins & Partner GbR**
**Theodor-Heuss-Strasse 1**
**38122 Braunschweig (DE)**

(56) Entgegenhaltungen:
**EP-A- 1 120 663**
**EP-A- 1 308 738**
**DE-A- 10 103 848**
**DE-A- 10 156 891**
**US-A- 5 539 318**
**US-A- 5 650 712**
**US-A- 5 744 931**
**US-A- 5 808 445**
**US-B1- 6 268 712**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).



Printed by Jouve, 75001 PARIS (FR)

## Beschreibung

Die Erfindung betrifft ein Verfahren zur Vorhersage von elektrischen Eigenschaften einer elektrochemischen Speicherbatterie.

Es besteht ein Bedarf, den Zustand einer elektrochemischen Speicherbatterie, wie beispielsweise den Ladezustand oder die Hochstrombelastbarkeit, aktuell zu bestimmen oder vorherzusagen. Beispielsweise sind für die Fähigkeit einer Starterbatterie, ein Kraftfahrzeug mit einem Verbrennungsmotor zu starten, der Ladezustand und der Alterungszustand bzw. der sich abzeichnende Kapazitätsverfall der Batterie maßgeblich, da die durch die Starterbatterie entnehmbare Stromstärke bzw. deren Leistungsabgabe begrenzt wird. Von besonderer Bedeutung ist die Ermittlung des Ladezustandes bzw. der Startfähigkeit einer Starterbatterie in den Fällen, in denen beispielsweise intermittierender Motorbetrieb vorliegt, da dann in den Motorstillstandzeiten das Bordnetz des Fahrzeugs mit seinen Verbrauchern weiter betrieben wird, allerdings der Generator keinen Strom erzeugt. Die Überwachung des Ladezustands und der Startfähigkeit der Speicherbatterie muss in solchen Fällen gewährleisten, dass der Energieinhalt der Speicherbatterie stets ausreichend bleibt, um den Motor noch zu starten.

Zur Messung des Ladezustands und der Bestimmung des Lastverhaltens von Speicherbatterien sind die verschiedensten Verfahren bekannt. So werden beispielsweise integrierende Messgeräte benutzt (Ah-Zähler), wobei der Ladestrom ggf. unter Bewertung mit einem festen Ladefaktor berücksichtigt wird. Da die nutzbare Kapazität einer Speicherbatterie stark von der Größe des Entladestroms und der Temperatur abhängig ist, kann auch mit solchen Verfahren keine zufriedenstellende Aussage über die der Batterie noch entnehmbare nutzbare Kapazität getroffen werden.

Aus der DE 22 42 510 C1 ist es beispielsweise bekannt, bei einem Verfahren zur Messung des Ladezustandes den Ladestrom mit einem von der Temperatur und vom Ladezustand der Batterie selbst abhängigen Faktor zu bewerten.

In der DE 40 07 883 A1 ist ein Verfahren beschrieben, bei dem die Startfähigkeit einer Speicherbatterie durch Messung der Batterieklemmenspannung und der Batterietemperatur und Vergleich mit einer für den zu prüfenden Batterietyp geltenden Ladezustandskurvenschar ermittelt wird.

Der DE 195 43 874 A1 ist ein Berechnungsverfahren für die Entladungscharakteristik und Restkapazitätsmessung einer Speicherbatterie zu entnehmen, bei dem ebenfalls Strom, Spannung und Temperatur gemessen wird, wobei die Entladungscharakteristik durch eine mathematische Funktion mit gekrümmter Oberfläche angenähert wird.

In der DE 39 01 680 C1 ist ein Verfahren zur Überwachung der Kaltstartfähigkeit einer Starterbatterie beschrieben, bei dem die Starterbatterie zeitweise mit einem Widerstand belastet wird. Die am Widerstand abfallende Spannung wird gemessen und daraus im Vergleich mit Erfahrungswerten festgestellt, ob die Kaltstartfähigkeit der Starterbatterie noch ausreicht. Zur Belastung der Starterbatterie dient dabei der Anlassvorgang.

Weiterhin ist in der DE 43 39 568 A1 ein Verfahren zur Ermittlung des Ladezustandes einer Kraftfahrzeug-Starterbatterie zu entnehmen, bei dem Batteriestrom und Ruhespannung gemessen werden und aus diesen auf den Ladezustand geschlossen wird. Dabei wird zusätzlich auch die Batterietemperatur berücksichtigt: Die während verschiedener Zeiträume gemessenen Ladeströme werden miteinander verglichen und daraus eine Restkapazität ermittelt.

In der DE 198 47 648 A1 ist ein Verfahren zum Erlernen eines Zusammenhangs zwischen der Ruhespannung und dem Ladezustand einer Speicherbatterie zum Zweck der Abschätzung der Speicherfähigkeit beschrieben. Aus der Beziehung der Ruhespannungsdifferenz zur während der Belastungsphase umgesetzten Strommenge wird ein Maß für die Säurekapazität des Elektrolyts der Speicherbatterie ermittelt. Dabei wird ausgenutzt, dass die Ruhespannung bei den in der für die Praxis relevanten höheren Ladezustandsbereichen annähernd linear mit dem Ladezustand ansteigt.

Das Problem bei der Ermittlung des Zustands einer elektrochemischen Speicherbatterie mit den vorbekannten Verfahren ist, dass insbesondere beim Entlade- und Ladebetrieb wiederaufladbarer Speicherbatterien, aber auch bei der lastfreien Lagerung Verschleiß auftritt und mit den herkömmlichen Verfahren nicht alle renlevanten Verschleißfaktoren berücksichtigt werden.

Bei Bleiakkumulatoren betrifft der Verschleiß einerseits Korrosionserscheinungen, welche die Spannungslage bei starken elektrischen Belastungen verschlechtern, andererseits Veränderungen der Morphologie: und der chemischen Zusammensetzung der aktiven Massen. Weiterhin führen parasitäre Reaktionen wie Elektrolyse und Korrosion von Gittern, aber auch einfache Verdampfung zu einem Verlust von Wasser aus dem Elektrolyten. Bei einem Akkumulator mit flüssigen Elektrolyten äußert sich dies in einem Absenken des Elektrolytspiegels. Dadurch werden zuvor mit Elektrolyt bedeckte Teile frei, was zu einer Änderung des Korrosionsverhaltens in diesen Bereichen führen kann. Zudem kann eine Säureschichtung durch Absinken der Säure in Schlieren auf dem Boden der Speicherbatterie auftreten, was zu einer Erhöhung der Säurekapazität im unteren Bereich und Erniedrigung der Säurekapazität im oberen Bereich führt. Bei Akkumulatoren mit festgelegten Elektrolyten, so genannten verschlossen Akkumulatoren bei denen der Elektrolyt zum Beispiel einem Glasfaservlies oder einem Gel immobilisiert ist, sinkt der Sättigungsgrad des aus den porösen Elektroden und mikroporösen Scheidern bzw. einem Gel bestehenden Elekrodensatzes mit Elektrolyt. Dies äußert sich unter anderem in einem erhöhten Innenwiderstand und einer zum Teil verminderten Kapazität. Weiterhin steigt mit zunehmender Austrocknung des Elektrodensatzes die Rate des parasitären Sauerstoffkreislaufes, welches einerseits bei Akkumulatoren dieser Bauart den Wasserverlust durch Elektrolyse reduziert, andererseits aber den Ladewirkungsgrad vermindern und die Erwärmung des Akkumulators bei der Ladung erhöhen kann.

In beiden Fällen steigt die Ruhespannung des Akkumulators bei gegebenen Entladegrad DoD an, weil der Verlust WL von Wasser bei unveränderter Menge an Schwefelsäure zu einer steigenden Konzentration des verdünnten Schwefelsäureelektrolyten führt und die Ruhespannung $U_{00}$ auf Grund elektrochemischer Zusammenhänge streng monoton mit der Säurekonzentration ansteigt.

US 6,268,712 B1 offenbart ein Verfahren zur Bestimmung der Startfähigkeit einer Autobatterie, bei dem Strom-Spannurigs-Paar zur Berechnung des Innenwiderstands genutzt werden.

In der DE 101 56 891 A1 ist ein Verfahren zur Überwachung einer Batterie beschrieben, bei dem während einer Hochstromphase ein differentieller Innenwiderstand und hieraus der Ladezustand bestimmt werden. Die Hochstromphase wird in zwei Phasen unterteilt.

US 5,650,712 A1 offenbart die Bestimmung eines ersten Ladezustandswertes in Abhängigkeit von dem Ladedurchsatz und Akkumulation desselben. Dieser akkumulierte Ladezustandswert wird mit einem abgespeicherten Ladezustandswert in Bezug gesetzt. Der abgespeicherte Ladezustandswert wird aus Kennlinien ausgelesen, die in Abhängigkeit von der Batteriespannung und der Temperatur abgelegt sind.

Aus dem Quotienten der Änderung des akkumulierten Ladezustands und der Änderung des gespeicherten Ladezustands wird eine Vollladekapazität bestimmt. Aus dem Quotienten der Vollladekapazität zur der Nennkapazität der Batterie wird ein Verschleißfaktor bestimmt.

Aufgabe der Erfindung ist es daher, ein verbessertes Verfahren zur Vorhersage von elektrischen Eigenschaften einer elektrochemischen Speicherbatterie zu schaffen.

EP-A-1120663 beschreibt ein Verfahren zur Bestimmung des Ladezustandes eines Akkumulators, wobei zwei in ihrem Ansatz unterschiedliche Methoden zur Ladezustandsbestimmung gleichzeitig angewendet werden, die einzeln erhaltenen Ergebnisse der unterschiedlichen Methoden entsprechend ihrer jeweiligen Zuverlässigkeit in der jeweiligen aktuellen bzw. zurückliegenden Betriebssituation des Akkumulators gewichtet werden, und der so erhaltene gewichtete Mittelwert der einzelnen Methoden als Ausgabegröße des Verfahrens verwendet und angezeigt wird.

Die Aufgabe wird erfindungsgemäß gelöst durch die Merkmale des unabhängigen Anspruchs 1.

Es wurde erkannt, dass die relevanten Verschleißparameter bei der Zustandsermittlung nahezu vollständig berücksichtigt werden, wenn der Ladezustand mit zwei unterschiedlichen Verfahren bezogen auf einen ersten und zweiten Parameter bestimmt wird. Es hat sich nämlich herausgestellt, dass sich beispielsweise der Wert der Säuredichte auf den auf die umgesetzte Ladungsmenge als bezogenen Ladezustandswert anders auswirkt, als auf den auf die Ruhespannung bezogenen Ladezustandswert.

Dann kann der aktuelle Zustand oder eine Vorhersage auf einen zukünftigen Zustand der Speicherbatterie unter Berücksichtigung sämtlicher relevanter Verschleißfaktoren erfolgen, indem aus dem funktionalen Zusammenhang zwischen den beiden jeweils auf einen anderen Parameter bezogenen Ladezustandswerte in einer zweiten Phase des Gebrauchs der Speicherbatterie eine Bezugnahme auf einen Zustandskenngrößenverlauf in einer ersten Phase des Gebrauchs der Speicherbatterie, vorzugsweise dem Neuzustand, erfolgt.

Diese oben genannten vielfältigen Effekte des Verschleisses von Speicherbatterien können nunmehr mit den erfindungsgemäßen Verfahren berücksichtigt werden, indem einfach der funktionale Zusammenhang zwischen dem auf einen ersten und einen zweiten Parameter bezogenen Ladezustandswertes $SOC_1$ und $SOC_2$ in einer ersten und zweiten Phase des Gebrauchs ausgewertet wird.

Vorzugsweise wird ein Zustandskenngrößenverlauf für die erste Phase des Gebrauchs als funktionaler Zusammenhang zwischen dem auf einen ersten Parameter der Speicherbatterie bezogenen Ladezustandswert und dem auf einen zweiten Parameter der Speicherbatterie bezogenen Ladezustandswert bestimmt. Dann ist die Änderung des Zustandskenngrößenverlaufs von der ersten Phase zur zweiten Phase ein Maß für den Zustand des Elektrolyts der Speicherbatterie, wie z. B. der Säurekapazität, des Wasserverlustes und/oder einer Säureschichtung des Elektrolyts.

Dadurch, dass der funktionale Zusammenhang in der ersten und zweiten Phase ermittelt wird, kann aus der Änderung direkt auf den Verschleiß geschlossen werden. Erfindungsgemäß wird dabei der Säureeinfluss unmittelbar aus der Änderung des Zustandskenngrößenverlaufs der ersten und zweiten Phase bestimmt.

Weiterhin ist es vorteilhaft, den funktionalen Zusammenhang der auf einen ersten und zweiten Parameter bezogenen Ladezustandswerte als Funktion der Ruhespannungsänderung nach einer Belastungsphase von der in der Belastungsphase umgesetzten Ladungsmenge zu bestimmen. Es wird somit vorgeschlagen, den Ladezustand in einem ersten Verfahren durch Messen der Ruhespannung und in einem zweiten Verfahren durch Messen der umgesetzten Ladungsmenge zu bestimmen. Dies ist gleichbedeutend mit dem Auftragen der Ruhespannungsänderung vor und nach einer elektrischen Belastungsphase über die während der elektrischen Belastungsphase umgesetzten Nettoladungsmenge, die gemessen, berechnet oder geschätzt werden kann. Es wird darauf hingewiesen, dass die umgesetzte Ladungsmenge nicht unmittelbar mit der während der elektrischen Belastungsphase gemessenen Strommenge gleichbedeutend ist. Parasitäre Reaktionen können dazu führen, dass ein Teil des Stroms nicht zu einer Ladezustandsänderung führt und eventuell gesondert berücksichtigt werden muss. Als erster Parameter wird somit eine Spannung der unbelasteten Speicherbatterie und als zweiter Parameter die umgesetzte Ladungsmenge, d. h. der Ladungsumsatz, festgelegt.

Zweckmäßigerweise wird jeweils eine Kenngröße S für die erste und zweite Phase aus dem Quotienten des auf den ersten Parameter bezogenen Ladezustandswertänderung zu der auf den zweiten Parameter bezogenen Ladezustandswertänderung bzw. aus der auf die während der elektrischen Belastungsphase umgesetzte Ladungsmenge bezogenen Ruhespannungsänderung bestimmt. Die Ruhespannungsänderung ist die Differenz der Ruhespannung nach der elektrischen Belastungsphase und der Ruhespannung vor der elektrischen Belastungsphase. Die Kenngröße S ist somit definiert als $S = \frac{\Delta SOC_1}{\Delta SOC_2} = \frac{\Delta SOC_1 (U_{00,2} - U_{00,1})}{\Delta SOC_2 (\Delta Q)}$. Aus der Änderung der Kenngröße S für die erste Phase und die zweite Phase wird dann der Zustand ermittelt.

Die Bestimmung der Ruhespannung kann durch Messung, Schätzung oder Berechnung mit Hilfe eines Models aus dem Spannungsverhalten auch im mit Strom belasteten Betriebszustand erfolgen.

In Abhängigkeit von der Kenngröße S kann dann für die erste Phase die Säurekapazität $Q_0$ der Speicherbatterie beispielsweise als Wert umgekehrt proportional zu der Kenngröße S bestimmt werden, wenn ein korrespondierender Spannungshub bekannt ist. Die Säurekapazität $Q_0$ ist die in elektrischen Äquivalenten ausgedrückte Elektrizitätsmenge, die in der im Akkumulator vorhandenen Schwefelsäure gespeichert ist.

Für das erfindungsgemäße Verfahren kann der Zustandskenngrößenverlauf für die erste Phase entweder für den Batterietyp fest vorgegeben, durch Messung bestimmt oder erlernt werden.

Zur Ermittlung eines auf die Ruhespannung bezogenen Ladezustands sollte die Ruhespannung im unbelasteten Zustand der Speicherbatterie nach einer ausreichenden Ruhephase gemessen werden. Es ist aber auch möglich, die Ruhespannung aus dem zeitlichen Verlauf der Batterieklemmenspannung während einer annähernd unbelasteten Phase oder aus dem Spannungs- und Stromverlauf während des Gebrauchs der Speicherbatterie zu berechnen. Die Bestimmung der Ruhespannung ist aus dem Stand der Technik hinreichend bekannt.

Ein aktueller auf die Säurekapazität des Elektrolyten als erster Parameter bezogener relativer Ladezustandswert kann für die erste Phase beispielsweise aus der aktuellen unbelasteten Spannung $U_0$ nach der Formel

$$SOC^{\cdot}_{1,rel} = \frac{U_0}{a} - b$$

berechnet werden, wobei a und b vom dem Typ der Speicherbatterie abhängige konstante Größen sind.

Es kann aber auch ein aktueller auf die Säurekapazität des Elektrolyten bezogener absoluter Ladezustandswert für die erste Phase, insbesondere nach der Formel

$$SOC^{\cdot}_{1,abs} = SOC^{\cdot}_{1,rel}(Q_0) \cdot Q_0$$

aus dem relativen Ladezustandswert $SOC_{1,rel}$ berechnet werden.

Weiterhin kann ein aktueller auf die Säurekapazität des Elektrolyten bezogener relativer Ladezustandswert $SOC_{1,abs}$ für die zweite Phase aus der aktuellen unbelasteten Spannung nach der Formel

$$SOC^{\cdot\cdot}_{1,rel} = \frac{S^{\cdot}}{S^{\cdot\cdot}} \left( \frac{U_0}{a} - b \right)$$

berechnet werden. Dabei sind a und b wiederum konstante Größen, S' die Kenngröße für die erste Phase und S" die Kenngröße für die zweite Phase der auf die während einer elektrischen Belastungsphase umgesetzten Ladungsmenge bezogenen Ruhespannungsänderung.

Weiterhin kann ein aktueller auf die Säurekapazität bezogener absoluter Ladezustandswert $SOC^{\cdot\cdot}_{1,abs}$ für die zweite Phase nach der Formel

$$SOC^{*}_{1,abs} = SOC^{*}_{1,rel} \cdot Q_0$$

aus dem relativen Ladezustand für die zweite Phase berechnet werden.

Die relativen oder absoluten Ladezustandswerte können angezeigt und/oder ausgewertet werden.

Das Verhältnis der Kenngröße S' für die erste Phase zur Kenngröße S" für die zweite Phase ist ein Maß für den Verschleiß der Speicherbatterie. Insbesondere kann unter Berücksichtigung des früheren Füllstands einer möglichen Säureschichtung und möglicher weiterer Einflussgrößen der Wasserverlust WL aus dem Verhältnis S'/S" bestimmt werden.

Weiterhin ist es vorteilhaft, das Ende der ersten Phase durch Integrieren des Ladungsdurchsatzes zu bestimmen. Die erste Phase wird dann beendet, wenn der integrierte Ladungsdurchsatz einen festgelegten Mindestwert überschreitet. Bei der Integration des Ladungsdurchsatzes werden vorzugsweise nur solche Beiträge berücksichtigt, bei denen die Veränderungen der Ladezustandswerte jeweils einen festgelegten Mindestwert überschreiten, so dass im Wesentlichen nur die Betriebszeit berücksichtigt wird, in der auch ein Verschleiß auftritt.

Alternativ oder zusätzlich hierzu kann als Kriterium für das Ende der ersten Phase eine festgelegte Mindestzeit nach Erstinbetriebnahme der Speicherbatterie oder eine festgelegte Mindestbetriebsdauer oder ein zur Säureschichtung führender Zustand überwacht werden.

Die Abweichung der aktuellen Kennlinie des funktionalen Zusammenhangs in der zweiten Phase von der Kennlinie in der ersten Phase vorzugsweise für eine neuwertige Speicherbatterie kann zudem zur Abschätzung der aktuellen Speicherfähigkeit bzw. der Minderung der Speicherfähigkeit gegenüber dem Ausgangszustand in der ersten Phase genutzt werden. Bei einer neuwertigen Speicherbatterie sollte die Speicherfähigkeit CSC 100 % betragen, d. h. die Speicherbatterie kann vollständig mit Energie geladen werden. Die Speicherfähigkeit CSC ist dabei als Ladungsmenge definiert, die der auf den maximal erreichbaren Ladezustand (Vollladung) geladenen Speicherbatterie mit dem Nenn-Entladestrom bis zum Erreichen der Entladeschluss-Spannung entnommen werden kann. Im Normalzustand entspricht sie etwa der Nennkapazität und vermindert sich bei einer Speicherbatterie durch Alterung oder Säureschichtung. Die Speicherfähigkeit der Speicherbatterie kann aus einer oder mehreren Kenngrößen G bestimmt werden. Ein Beispiel für eine technische Realisierung wird wie folgt beschrieben:

Die Speicherfähigkeit der Speicherbatterie wird durch die jeweilige Extrapolation des funktionalen Zusammenhangs f" auf einen Ladezustandswert $SOC_1$ =0 oder $SOC_2$=0 bestimmten Punkten oder Abschnitten der Kurve (vorzugsweise für $SOC_1$ und/oder $SOC_2$> 50%), der Extrapolation des Zustandskenngrößenverlaufs f' auf einen Ladezustandswert $SOC_1$ = 0 und $SOC_2$= 0 und durch Ermittlung je einer charakteristischen Kenngröße G aus der Differenz beider Werte bestimmt:

$$G_2 = f''(SOC_1 = 0) - f'(SOC_1 = 0)$$

$$G_1 = f''(SOC_2 = 0) - f'(SOC_2 = 0).$$

Aus beiden Größen kann nun die Speicherfähigkeit CSC durch folgende Beziehung ermittelt werden:

$$CSC = 100 - MAX(G_1, G_2).$$

Aufgrund der MAX-Auswahl werden nur Werte größer als Null verwendet.

Das beschriebene Beispiels stellt den einfachsten Fall dar. Bei weniger guten Verhältnisses kann es erforderlich sein, dass eine einfache Extrapolation nicht zum Ergebnis, sondern eine Auswertung weiterer charakteristischer Größen erfolgen muss. Beispiel hierfür sind Krümmungsgrade, Ableitungen etc. von Kurven für den funktionalen Zusammenhang f'', die keine Geraden sind.

Weiterhin kann es auch ausreichend sein, nur die noch entnehmbare Ladungsmenge im aktuellen Zustand der Speicherbatterie $SOC_1$, $SOC_2$ zu kennen und nicht den auf die vollgeladene Speicherbatterie bezogenen Wert der Speicherfähigkeit CSC. Wenn der Ladezustandswert $SOC_1$ aus der Ruhespannung ermittelt wird und der Ladezustandswert $SOC_2$ aus dem Ladungsdurchsatz besteht, z. B. ein Problem, einen genauen Ladezustandswert $SOC_2$ zu erhalten,

da durch Integrationsfehler mit fortlaufender Zeit der Wert für den Ladungsdurchsatz ungenauer wird. In diesem Falle ist es dann zwar immer noch sinnvoll, den Zustandskenngrößenverlauf f" aufzunehmen, aber dann nur noch die entnehmbare Ladungsmenge vom aktuellen Zustand ausgehend zu berechnen. Das funktioniert, wenn der funktionale Zusammenhang f" vergleichsweise zeitnah zu dem Vorhersagezeitpunkt aufgenommen wurde und die Steigung des funktionalen-Zusammenhangs f" bekannt ist. In diesem Fall wird der auf den zweiten Parameter bezogene Ladezustandswert $SOC_2$" für die zweite Phase aus dem funktionalen Zusammenhang f'' mit dem auf den ersten Parameter bezogene Ladezustandswert $SOC_1 = 0$ und aus der Differenz $SOC_2$-$SOC''_2$ durch Multiplikation mit der Batteriekapazität die noch entnehmbare Ladungsmenge ermittelt.

Eine weitere Aufgabe ist häufig, dass eine Spannungsänderung $\Delta U$ unter einer Strombelastung i vorhergesagt werden muss. Dafür muss, wenn Säureschichtung vorliegt, ein Ladezustand als der relevante Wert für die Berechnung der Spannungslage ermittelt werden, da dann beide Methoden für die Ladezustandsbestimmung unterschiedliche Werte ergeben. Der dann für die Spannungslage relevante Ladezustandswert ist der auf die Ruhespannung bezogene Ladezustandswert ($SOC_1$).

Weiterhin ist es häufig erforderlich, dass die Spannungsänderung bzw. die Spannungslage der Speicherbatterie vorhergesagt werden muss, wenn der Speicherbatterie ausgehend vom aktuellen Zustand eine bestimmte Ladungsmenge entnommen wird. Bei Batterien ohne Säureschichtung ist die Abhängigkeit generell bekannt, da einfach der relevante Ladezustandswert entsprechend der Ladungsmenge verändert werden muss. Bei Batterien mit Schichtung kann die Charakteristik des relevanten Ladezustands über der entnommenen Ladungsmenge sich anders verhalten. Bei Speicherbatterien mit Säureschichtung hat sich gezeigt, dass nur eine Lösung, wie sie nachstehend beschrieben ist, zu einer guten Vorhersage der Spannungslage führt.

Zur Ermittlung einer zu erwartenden Spannungsänderung bei einer elektrischen Belastung der Speicherbatterie und einer Temperatur erfolgt ein

- Bestimmen der Ruhespannung der Speicherbatterie zu einem ersten Zeitpunkt in der zweiten Phase,
- Ermitteln der nach einem Ladungsdurchsatz zwischen dem ersten Zeitpunkt und einem zweiten Zeitpunkt zu erwartenden Ruhespannung aus dem funktionalen Zusammenhang für die zweite Phase, und
- Bestimmen der zu erwartenden Spannungsänderung aus der ermittelten zu erwartenden Ruhespannung, dem auf den ersten Parameter bezogenen Ladezustand zum zweiten Zeitpunkt und einer Funktion des elektrischen Innenwiderstandes in Abhängigkeit von dem auf den ersten Parameter bezogene Ladezustandswert, und
- Ermitteln einer zu erwartenden Spannung als Differenz der für den zweiten Zeitpunkt erwarteten Ruhespannung und dem Produkt aus Innenwiderstand und angenommenem Stromwert.

Hierbei wird die Erkenntnis ausgenutzt, dass der Einfluss der Säureschichtung oder Alterung bei der Ermittlung der zu erwartenden Ruhespannung aus dem funktionalen Zusammenhang für die zweite Phase bereits berücksichtigt ist und mit dieser Kenngröße auf einen im Wesentlichen von der Säureschichtung unabhängigen funktionalen Zusammenhang zwischen Spannungsänderung und Ruhespannung zurückgegriffen werden kann.

Aus der zu erwartenden Spannungsänderung kann weiterhin eine zu erwartende Spannung als Differenz zwischen der für den zweiten Zeitpunkt erwarteten Ruhespannung und der ermittelten Spannungsänderung berechnet werden.

Die Erfindung wird nachfolgend anhand der beigefügten Zeichnungen beispielhaft näher erläutert. Es zeigen:

Figur 1 - einen funktionalen Zusammenhang zwischen dem auf einen ersten Parameter bezogenen Ladezustandswert und dem auf einen zweiten Parameter bezogenen Ladezustandswert für eine erste Phase und eine zweite Phase des Gebrauchs einer Speicherbatterie;

Figur 2 - ein Diagramm des funktionalen Zusammenhangs zwischen dem Ladezustandswert einer Speicherbatterie und der spezifischen Dichte des Elektrolyten im Neuzustand und nach einem Wasserverlust;

Figur 3 - Darstellung des Einflusses der Alterung und der Säureschichtung auf den Verlauf des funktionalen Zusammenhangs zwischen der Ruhespannung und der umgesetzten Ladungsmenge;

Figur 4 - ein Flussdiagramm zur Vorhersage einer sich einstellenden Spannung der Speicherbatterie unter Last zur Hochstromprädiktion;

Figur 5 - ein Diagramm des funktionalen Zusammenhangs in einer ersten und zweiten Phase und des Verlaufs der Minimalspannung in Abhängigkeit von dem auf die Ruhespannung bezogenen Ladezustandswert mit den Verfahrensschritten zur Hochstromprädiktion;

Figur 6 - funktionaler Zusammenhang zwischen dem auf den ersten Parameter bezogenen Ladezustand und auf einen zweiten Parameter bezogenen Ladezustand und Bestimmung der Speicherfähigkeit;

Figur 7 - Diagramm der Qualität der Bestimmung der Speicherfähigkeit mit dem erfindungsgemäßen Verfahren;

Figur 8 - Diagramm des funktionalen Zusammenhangs zwischen dem auf einen ersten Parameter bezogenen Ladezustandswert und dem auf einen zweiten Parameter bezogenen Ladezustandswert mit der Darstellung des Verfahrens zur Bestimmung der im aktuellen Zustand entnehmbaren Ladungsmenge.

Die Figur 1 lässt ein Diagramm des funktionalen Zusammenhangs zwischen dem auf einen ersten Parameter bezogenen Ladezustandswert $SOC_1$ und dem auf einen zweiten Parameter bezogenen Ladezustandswert $SOC_2$ in einem ersten Zeitpunkt (funktionaler Zusammenhang f') und einem späteren zweiten Zeitpunkt (funktionaler Zusammenhang f'') erkennen. In der ersten Phase des Gebrauchs der Speicherbatterie liegt in dem dargestellten Beispiel keine Säureschichtung vor und die Säureeigenschaften sind nahezu optimal. In der zweiten Phase des Gebrauchs hat sich eine Säureschichtung eingestellt, bei der die Säuredichte im unteren Bereich der Speicherbatterie höher als im oberen Bereich der Speicherbatterie ist.

Die Säureschichtung führt dazu, dass die Steilheit S" des funktionalen Zusammenhangs f'' in der zweiten Phase im Vergleich zu der Steilheit S' des funktionalen Zusammenhangs f' in der ersten Phase auf Grund des Säureeinflusses zunimmt.

In dem dargestellten Beispiel wurde als erster Parameter die Ruhespannung $U_{00}$ und als zweiter Parameter die während einer Belastungsphase umgesetzte La-Ladungsmenge $\Delta Q$ bestimmt. Dies entspricht einem Diagramm, bei dem die Ruhespannungsänderung $\Delta U_{00}$ über der in der zugehörigen elektrischen Belastungsphase umgesetzten Ladungsmenge $\Delta Q$ aufgetragen ist.

Erfindungsgemäß wird in einer ersten Phase des Gebrauchs ein Zustandskenngrößenverlauf f' festgelegt oder bestimmt, der beispielsweise der in der Figur 1 dargestellte funktionale Zusammenhang f' zwischen dem aus der Ruhespannung $U_{00}$ ermittelten ersten Ladezustandswerten $SOC_1$ und den aus den umgesetzten Ladungsmengen Q bestimmten Ladezustandswerten $SOC_2$ sein kann.

Zur Hochstromprädiktion kann aber auch beispielsweise der Verlauf der Minimalspannung $U_{min}$ in Abhängigkeit von dem auf die Ruhespannung bezogenen Ladezustand $SOC_1$ bestimmt werden.

Aus dem funktionalen Zusammenhang f'' für die zweite Phase kann dann ein aktueller Zustandswert durch Bezugnahme auf den Zustandskenngrößenverlauf f' für die frühere erste Phase bestimmt oder ein zukünftiger Zustand vorhergesagt werden. Der Zustand beinhaltet dann bereits sämtliche relevanten Verschleißeinflüsse, insbesondere den Säureeinfluss.

Als Zustandskenngrößen können der Ladezustand, die gesamte Speicherfähigkeit, der Innenwiderstand, die Hochstromfähigkeit, die Belastbarkeit, der Ladewirkungsgrad, die Erwärmung, die Temperatur und die Temperaturverteilung innerhalb der Speicherbatterie etc. bestimmt werden, wobei das beschriebene Verfahrern mit anderen Zustandsermittlungsverfahren verknüpft werden kann. Auch eine Phasenänderung von Komponenten der Speicherbatterie, zum Beispiel eine Erstarrung des Elektrolyten, kann gegebenenfalls unter Zuhilfenahme weiterer bekannter Verfahren mit dem erfindungsgemäßen Verfahren ermittelt werden, da die Erstarrungstemperatur durch den Wasserverlust WL und eine Säureschichtung verändert wird.

Beispielsweise kann der Verschleiß z. B. durch Wasserverlust WL und/oder Säureschichtung aus dem geänderten Zusammenhang zwischen der Ruhespannung $U_{00}$ und dem Ladezustand wie folgt bestimmt werden:

Es werden Kenngrößen S' für eine erste Phase und S" für eine zweite Phase des Gebrauchs der Speicherbatterie bestimmt jeweils durch
Bestimmung der Ruhespannung $U_{00,1}$ vor einer elektrischen Beiastungsphase,
Bestimmung der Ruhespannung $U_{00,2}$ nach einer elektrischen Belastungsphase,
Bestimmung der während dieser Belastungsphase umgesetzten Ladungsmenge $\Delta Q$.

Die Kenngröße S wird dann nach der Formel

$$S = \frac{\Delta SOC_1}{\Delta SOC_2} = \frac{\Delta SOC_1 (U_{00,2} - U_{00,1})}{\Delta SOC_2 (\Delta Q)}$$

bestimmt und entspricht dem Ouotienten der Änderung des auf den ersten Parameter $U_{00}$ bezogenen Ladezustandswertes $\Delta SOC_1$ zu der Änderung des auf den zweiten Parameter Q bezogenen Ladezustandswertes $\Delta SOC_2$. Für die erste Phase des Gebrauchs der Speicherbatterie, vorzugsweise im Neuzustand, ergibt sich für die Kenngröße S' ein anderer Wert, als in einer späteren zweiten Phase, in der beispielsweise ein Wasserverlust WL oder eine Säureschichtung eingetreten ist.

Die Figuren 1 und 2 lassen dies erkennen. In der Figur 2 ist der auf die Ruhespannung bezogene Ladezustandswert $SOC_1$ über die spezifische Dichte des Elektrolyten für die erste Phase im Neuzustand und die zweite Phase nach Verschleiß V am Beispiel eines Bleiakkumulators mit sechs in Serie geschalteten Zellen aufgetragen.

Die für die erste Phase charakteristische Kenngröße S' wird entweder durch Messung, Schätzung oder Berechnung bestimmt oder ist für den Typ der Speicherbatterie fest vorgegeben. Nach Abschluss der ersten Phase wird die Kenngröße S' nicht mehr verändert.

Die Kenngröße S" wird in der zweiten Phase aktualisiert und beinhaltet in ihrer fortschreitenden Veränderung eine Information über den Verschleiß. Als Maßzahl für den Verschleiß kann zum Beispiel die relative Veränderung

$\left(\frac{S'' - S'}{S''}\right)$ oder das Verhältnis $\frac{S''}{S'}$ o.ä. gewählt werden.

Mit der Veränderung der Kenngröße S als Folge des Verschleisses ändert sich auch der Zusammenhang zwischen der gemessenen oder der geschätzten Ruhespannung $U_{00}$ und dem Ladezustandswert SOC. Aus der Figur 2 ist erkennbar, dass mit einer gewissen Änderung der Elektrolytsäuredichte bzw. der Ruhespannung $U_{00}$ in der zweiten Phase ein kleinerer Ladungsumsatz, d. h. eine geringere Änderung des Ladezustandes, verbunden ist, als in der ersten Phase. Wenn der Verschleiß jedoch beispielsweise aus dem oben genannten Verfahren bekannt ist, so kann diese Veränderung für eine korrigierte Ladezustandsaussage berücksichtigt werden.

So kann beispielsweise der tatsächliche Ladezustand SOC" in der zweiten Phase aus dem Ladezustandswert $SOC_1$, der sich aus einer bestimmten Ruhespannung $U_{00}$ ergeben würde, für diese Ruhespannung $U_{00}$ mit der Formel

$$SOC'' = \left(\frac{S'}{S''}\right) \cdot SOC_1$$

bestimmt werden.

Die Entscheidung, ob sich die Speicherbatterie noch in der ersten Phase des Gebrauchs oder bereits in der zweiten Phase befindet, kann beispielsweise anhand einer festgelegten Mindestdauer nach Installation der Speicherbatterie oder einer Mindestbetriebsdauer getroffen werden. Es kann aber auch vom Zeitpunkt der Erstinbetriebnahme der Ladungsdurchsatz integriert werden und die erste Phase beendet werden, sobald der integrale Ladungsdurchsatz einen Mindestwert über schreitet. Dabei werden vorzugsweise nur solche Beiträge des Ladungsdurchsatzes berücksichtigt, bei denen die Veränderungen der Ladezustandswerte jeweils einen Mindestwert überschreiten.

Für die Auswertung ist es unter Umständen zweckmäßig einen aktuellen auf die Nennkapazität $K_{nom}$ bezogenen relativen Ladezustandswert $SOC_{1,rel}$ ($K_{nom}$) aus dem auf die Säurekapazität $Q_0$ bezogenen relativen Ladezustandswert $SOC_{1,rel}$ ($Q_0$). beispielsweise nach der Formel

$$SOC_{1,rel}(K_{nom}) = \frac{(a + (b - a) \cdot (SOC_{1,rel}(Q_0)) - f_0)}{(f_1 - f_0)}$$

zu berechnen. Hierbei sind a und b festgelegte Ladezustandswerte mit a<b. $f_0$ ist der zu dem relativen Ladezustandswert $SOC_{1,rel}(K_{nom})$=a korrespondierende auf die Säurekapazität $Q_o$ bezogene Ladezustandswert $SOC_{1,rel}$ ($Q_0$) und $f_1$ der zu dem relativen Ladezustand $SOC_{1,rel}(K_{nom})$=b korrespondierende auf die Säurekapazität $Q_0$ bezogene Ladezustandswert $SOC_{1,rel}$ ($Q_0$).

Aus dem relativen Ladezustandswert $SOC_{1,rel}$ ($K_{nom}$) kann ein aktueller auf die Nennkapazität $K_{nom}$ bezogener absoluter Ladezustandswert $SOC_{1,abs}$ ($K_{nom}$) nach der Formel

$$SOC_{1,abs}(K_{nom}) = SOC_{1,rel}(K_{nom}) \cdot K_{nom}$$

berechnet und ausgewertet werden.

Als Zustandskenngröße kann somit beispielsweise der oben beschriebene korrigierte Ladezustandswert SOC", ein auf die Säurekapazität $Q_0$ bezogener relativer Ladezustandswert $SOC_{1,rel}$, ein auf die Säurekapäzität $Q_0$ bezogener absoluter Ladezustandswert $SOC_{1,abs}$, eine auf die Nennkapazität $K_{nom}$ bezogener relativer Ladezustand $SOC_{1,rel}$ ($K_{nom}$) oder ein auf die Nennkapazität $K_{nom}$ bezogener absoluter Ladezustand $SOC_{1,abs}$ ($K_{nom}$) berechnet und ausgewertet werden.

Die Figur 3 lässt eine Skizze mit dem Einfluss der Alterung und der Säureschichtung auf dem Verlauf des funktionalen Zusammenhangs zwischen der Ruhespannung $U_{00}$ und der umgesetzten Ladungsmenge $\Delta$ Q erkenneh. Die Speicherbatterie ist als mit schwarz skizzierter Ladung auffüllbares Reservoir skizziert, aus dem Ladung über den rechts unten skizzierten Ablauf abfließen kann. Die Figur 3 a) zeigt den Zustand der Speicherbatterie-Neuzustand, bei dem die Speicherfähigkeit CSC unvermindert ist und 100 % beträgt. Das Reservoir lässt sich somit vollständig füllen. Im Neuzustand ist der funktionale Zusammenhang zwischen der Ruhespannung $U_{00}$ und der umgesetzten Ladungsmenge $\Delta$ Q eine Gerade, die eine definierte, von dem Typ der jeweiligen Speicherbatterie abhängige Steigung hat.

Die Figur 3 b) zeigt eine gealterte Speicherbatterie mit einer durch den Alterungseinfluss geminderten Speicherfähigkeit CSC". Die Verminderung $Q_v$ derS-Speicherfähigkeit wirkt sich allerdings nicht auf die Lade- und Entladephasen aus, sondern führt lediglich zu einer früheren Erschöpfung des Akkumulators. Grundsätzlich bleibt der funktionale Zusammenhang zwischen der Ruhespannung $U_{00}$ und der umgesetzten Ladungsmenge $\Delta Q$ daher erhalten, die Gerade endet jedoch im unteren Bereich beim Wert der Ladungsverminderung $Q_v$ auf der Abszisse des Ladungsumsatzes $\Delta Q$.

Die-Figur 3c) lässt den Einfluss der Säureschichtung auf eine Speicherbatterie erkennen. Dies wirkt sich im gesamten Raum des Reservoirs sowohl im niedrigen, als auch im hohen Ladezustandsbereich aus und führt bei dem funktionalen Zusammenhang bei der Ruhespannung $U_{00}$ und der umgesetzten Ladungsmenge $\Delta Q$ zu einem steileren Kurvenverlauf.

Die Figur 3 d) lässt sowohl den Einfluss des Alterungseinflusses als auch der Säureschichtung auf die Speicherfähigkeit CSC und den funktionalen Zusammenhang zwischen der Ruhespannung $U_{00}$ und der umgesetzten Ladungsmenge $\Delta Q$ erkennen. Es wird deutlich, dass die Speicherfähigkeit CSC um die Ladungsverminderung $Q_v$ im unteren Bereich und über den gesamten Rauminhalt um den Einfluss der Säureschichtung vermindert ist. Dies führt bei dem funktionalen Zusammenhang zu einem am Punkt der Ladungsverminderung $Q_v$ auf der Abzisse abgebrochenen und im Vergleich zu dem Neuzustand der Speicherbatterie steileren Kurvenverlauf.

Die Speicherfähigkeit CSC ist die Ladungsmenge, die der auf den maximal erreichbaren Ladezustand (Vollladung) geladenen Speicherbatterie mit dem Nenn-Entladestrom bis zu dem Erreichen der Entladeschluss-Spannung entnommen werden kann. Im Normalzustand entspricht sie etwa der Nennkapazität. Im gealterten Zustand, auch bei Eintritt von Säureschichtung, vermindert sie sich, wie in den Figuren 3 c) und 3 d) skizziert ist. Bei Kenntnis der Speicherfähigkeit CSC kann bei bekannten Ladezustand SOC auch auf die aus diesem Zustand mit Nennstrom noch entnehmbare Ladungsmenge Q geschlossen werden.

Mit der in den Figuren1 und 3 skizzierten Änderung des funktionalen Zusammenhangs zwischen dem auf die Ruhespannung $U_{00}$ bezogenen ersten Ladezustand $SOC_1$ und dem auf den Ladungsumsatz $\Delta Q$ bezogenen zweiten Ladezustand $SOC_2$ lässt sich die unbelastete Klemmenspannung $U_{00,2}$ in einem anderen Zeitpunkt $t_2$ in der zweiten Phase bestimmen, wenn zwischenzeitlich ein Ladungsumsatz $\Delta Q$ erfolgt ist. Diese so berechnete unbelastete Klemmspannung $U_{00,2}$ wird als Parameterwert genutzt, um einen Spannungssprung $\Delta U$ unter einer elektrischen Belastung i bei einer Temperatur T zu berechnen, wobei die dabei verwendete Abhängigkeit zu einem früheren Zeitpunkt bestimmt oder sogar fest vorgegeben ist. Die unbelastete Klemmenspannung $U^*_{00,2}$ wird auch als Aufpunkt für die Berechnung einer Spannung U unter Last nach der Formel $U=U_{00} - \Delta U$ genutzt.

Diese sogenannte Hochstromprädiktion ist in der Figur 4 skizziert

Zunächst (Schritt a) werden zu mehreren Zeitpunkten $t_1$ die unbelasteten Ruhespannungen $U^{*}_{00,1}$ bei unterschiedlichen Entladetiefen DoD bzw. auf den ersten Parameter bezogenen Ladezustandswerten $SOC_1$ bestimmt, um einen funktionalen Zusammenhang f" für die zweite Phase aufzunehmen.

Die Ruhespannung $U_{00}$ ist hierbei die Spannung der Speicherbatterie an einem bestimmten, durch die Temperatur T und den Ladezustand SoC gekennzeichneten Zustand, welche sich nach einer gewissen Zeit nach Ende einer elektrischen Belastung einstellt. In einer Speicherbatterie laufen im allgemeinen neben den Hauptreaktionen der Ladung und Entladung an den beiden Elektroden auch innere Umladungen und parasitäre Reaktionen ab, wie zum Beispiel spontane Gasentwicklung, welche die Zellspannung beeinflussen. Diese Effekte sind besonders groß, wenn der Phase nach Ende einer elektrischen Belastung, in der die Ruhespannung $U_{00}$ bestimmt werden soll, eine Ladung voranging. Daher muss auf reproduzierbare Bedingungen bei der Bestimmung der Ruhespannung $U_{00}$ Wert gelegt werden. Vorzugsweise wird die Ruhespannung $U_{00}$ in einem Zustand der Speicherbatterie bestimmt, dem eine Entladung von mindestens cirka 3 - 5 % der Speicherfähigkeit CSC voranging. Dann stellt sich bei Raumtemperatur nach etwa 1 - 4 Stunden eine sehr stabile reproduzierbare Ruhespannung $U_{00}$ ein. Ersatzweise kann in anderen Fällen, wenn z. B. eine starke Ladung voranging, eine zusätzliche Ladungsmenge von z. B. 5 % der Speicherfähigkeit CSC mit einem 20-stündigen Strom $I_{20}$ eingeladen und anschließend wieder entladen werden. Die sich dann nach weiteren1 - 4 Stunden bei Raumtemperatur einstellende Spannung U liegt sehr nahe der Ruhespannung $U_{00}$.

Dabei wird während einer Belastungsphase (Schritt b) der bei Ladung in die Speicherbatterie fließende und bei Entladung aus der Speicherbatterie fließende Strom I gemessen und durch Integration (Schritt c) die während der Belastungssphase umgesetzte Ladungsmenge $\Delta Q$ (t) bestimmt.

Aus den Ruhespannungen $U_{00}$ und dem ermittelten Ladungsumsatz $\Delta Q$ (t) wird für die zweite Phase des Gebrauchs der Speicherbatterie ein funktionaler Zusammenhang zwischen der Ruhespannung $U_{00}$ und dem Ladungsumsatz $\Delta Q$ ermittelt, wobei auch Verfahren der Interpolation, Extrapolation und Linearisierung zur Hilfe genommen werden können (Schritt d).

Zur Vorhersage einer Ruhespannung $U_{00,2}$ zu einem späteren zweiten Zeitpunkt $t_2$ in der zweiten Phase nach einem bestimmten Ladungsumsatz $\Delta Q$ wird in einem Schritt e) zum aktuellen Zeitpunkt $t_1$ eine Ruhespannung $U_{00,2}$ bestimmt.

In einem Schritt f) wird der erwartete Ladungsumsatz $\Delta Q$ vom aktuellen Zeitpunkt $t_1$ zum zukünftigen zweiten Zeitpunkt $t_2$ bestimmt. Aus diesen Werten wird unter Zuhilfenahme des im Schritt d) bestimmten funktionalen Zusammenhangs die zu erwartende Ruhespannung $U^{\bullet}_{00,2}$ zum späteren zweiten Zeitpunkt $t_2$ vorhergesagt (Schritt g).

Zur Vorhersage einer Spannung $U_2$ unter Last zu dem zweiten Zeitpunkt $t_2$ aus der derart vorhergesagten Ruhespannung $U_{00,2}$ bei einer Temperatur $T_2$ zum zweiten Zeitpunkt $t_2$ und Belastungsstrom $I_2$ wird in einem Schritt h) die für die Speicherbatterie charakteristische Funktion des Spannungsabfalls von der Ruhespannung $U_{oo}$, dem Belastungsstrom I und der Temperatur T bestimmt, festgelegt oder auf eine solche Funktion zurückgegriffen.

In einem Schritt i) wird die zu erwartende Temperatur $T_2$ zum zweiten Zeitpunkt $t_2$ bestimmt, festgelegt oder vorhergesagt.

In einem Schritt k) wird dann der Spannungsabfall $\Delta U$ zum zweiten Zeitpunkt $t_2$ unter der Belastung mit dem Strom $I_2$ aus dem funktionalen Zusammenhang mit Schritt h) und der Ruhespannung $U_{00,2}$ und der Temperatur $T_2$ durch Auslesen der zugehörigen Wert aus der Kurvenschar vorhergesagt.

In einem Schritt l) wird dann aus der Ruhespannung $U_{00,2}$ und dem Spannungabfall $\Delta U$ die zu erwartende Spannung unter Last $U_2$ als Differenz

$$U_2 = U_{00,2} - \Delta U$$

vorhergesagt.

Die Figur 5 lässt den Ablauf des Verfahrens zur Hochstromprädiktion anhand des funktionalen Zusammenhangs zwischen dem auf die Ruhespannung $U_{00}$ bezogenen Ladezustandswert $SOC_1$ und den auf den Ladungsumsatz $\Delta Q$ bezogenen Ladezustandswert $SOC_2$ erkennen. Dabei wird ausgenutzt, dass die Minimalspannung $U_{min}$ in Abhängigkeit von dem auf die Ruhespannung $U_{00}$ bezogenen ersten Ladezustandswert $SOC_1$ eine gute Übereinstimmung im Kurvenverhalten mit und ohne Säureschichtung aufweist. Die Prädiktion der Minimalspannung $U_{min}$ basiert daher auf dem Ladezustandswert SOC, der auf die Ruhespannung $U_{00}$ bezogen ist.

Für die zweite Phase, bei der unter Umständen eine Säureschichtung vorliegt, wird in einem ersten Schritt a) die Ruhespannung $U_{00}$ vor und nach einer Belastungsphase sowie die während der Belastungsphase umgesetzte Menge $\Delta Q$ bestimmt und hieraus der für die zweite Phase mit Säureschichtung dargestellte Kurvenverlauf f" als gegenüber der ersten Phase (f') ohne Säureschichtung verlagerter und gekippter Geraden bestimmt.

Für einen zweiten Zeitpunkt $t_2$ in der zweiten Phase wird aus dem Kurvenverlauf f" der bei einem bestimmten Ladezustandswert SOC zu erwartende auf die Ruhespannung $U_{00}$ bezogene Ladezustandswert $SOC^{\bullet}_1$ bestimmt. In dem in der Figur 5 dargestellten Beispiel beträgt dieser 40 % bei einem Entladegrad von etwa 55 %.

In einem Schritt c) wird nun aus dem bekannten funktionalen Zusammenhang der Minimalspannung $U_{min}$ von dem auf die Ruhespannung $U_{00}$ bezogenen Ladezustandswert $SOC^{\bullet}_1$ die bei dem vorher ermittelten Ladezustandswert $SOC^{\bullet}_1$ =40% zu erwartende Mininimalspannung $U_{min}$=9V ausgelesen. Diese Minimalspannung $U_{min}$ kann ausgegeben

oder beispielsweise zur Bewertung genutzt werden, ob im zweiten Zeitpunkt $t_2$ der Ladezustandswert SOC z. B. zum Starten eines Kraftfahrzeuges noch ausreichend ist.

Der funktionale Zusammenhang zwischen der Minimalspannung $U_{min}$ und dem auf die Ruhespannung $U_{00}$ bezogenen Ladezustandswert $SOC_1^{*}$ kann auch eine von der Temperatur T und einem Entladestrom I abhängige Kurvenschar sein.

Die Speicherfähigkeit der Speicherbatterie kann aus einer oder mehreren Kenngrößen G bestimmt werden. Dieses wird anhand eines Beispiels für die technische Realisierung mit Hilfe der Figuren 6 und 7 nachfolgend erläutert. Die Figur 6 zeigt ein Diagramm des funktionalen Zusammenhangs zwischen dem auf einen ersten Parameter bezogenen Ladezustandswert $SOC_1$ und dem auf einen zweiten Parameter bezogenen Ladezustandswert $SOC_2$ mit weiteren Geraden zur Bestimmung der Speicherfähigkeit CSC.

Hierzu wird die Speicherfähigkeit CSC der Speicherbatterie bestimmt durch jeweilige Extrapolation des funktionalen Zusammenhangs f" auf einen Ladezustandswert $SOC_1 = 0$ oder $SOC_2=0$ in bestimmen Punkten oder Abschnitten der Kurve, insbesondere für Ladezustandswerte $SOC_1$ und/oder $SOC_2$ von größer als 50%. Weiterhin erfolgt eine Extrapolation des Zustandskenngrößenverlaufes f' auf einen Ladezustandswert $SOC_1=0$ und $SOC_2=0$. Dann wird jeweils eine auf den ersten Parameter und auf den zweiten Parameter charakteristische Kenngröße $G_1$, $G_2$ aus der Differenz der extrapolierten Werte wie folgt ermittelt.

$$G_2=f''(SOC_1=0)-f'(SOC_1=0)$$

$$G_1=f''(SOC_2=0)-f'(SOC_2=0).$$

Aus beiden Größen kann nun durch folgende Beziehung die Speicherfähigkeit CSC ermittelt werden:

$$CSC=100\%-MAX(G_1,G_2).$$

In dem dargestellten Beispiel wird der Zustandskenngrößenverlauf f' auf den Wert $SOC_1=0$ extrapoliert. Weiterhin wird der funktionale Zusammenhang f", der in der zweiten Phase mit Säureschichtung aufgenommen wurde, ebenfalls auf den Ladezustandswert $SOC_1$ =0 extrapoliert. Der Zustandskenngrößenverlauf f' wurde im Unterschied zu dem funktionalen Zusammenhang f'' in einer früheren ersten Phase aufgenommen, als noch keine Alterung oder Säureschichtung vorlag.

Der Zustandskenngrößenverlauf verläuft bei der Extrapolation nahezu durch den Nullpunkt, so dass sich die charakteristische Kenngröße $G_2$=40% ergibt. Damit beträgt die Speicherfähigkeit CSC 100% -40% = 60%. Für die auf den zweiten Parameter bezogene charakteristische Kenngröße $G_1$ mit $SOC_2$=0 würde sich der Wert aus der Zustandskenngröße f' von etwa Null ergeben. Der sich aus dem funktionalen Zusammenhang f" für die zweite Phase ergebende Wert bei einem angenommenen Ladezustandswert $SOC_2$=0 wäre negativ.

Für die Bestimmung Speicherfähigkeit CSC wird daher der auf den ersten Ladezustandswert $SOC_1$ bezogene charakteristische Kenngröße $G_2$ eingesetzt.

Die Figur 7 lässt die Qualität der Bestimmung der Speicherfähigkeit CSC mit dem oben beschriebenen Verfahren erkennen. Es wird deutlich, dass die Abweichungen zwischen der gemessenen Speicherfähigkeit und der nach dem erfindungsgemäßen Verfahren bestimmten Speicherfähigkeit CSC für Versuche mit unterschiedlichem Ablauf (♦) bzw. Start aus geladenem Zustand (Start aus entladenem Zustand (■) innerhalb einer akzeptablen Toleranz liegt.

Die Figur 8 lässt ein Diagramm des funktionalen Zusammenhangs zwischen dem auf einen ersten Parameter bezogene Ladezustandswert $SOC_1$ und dem auf einen zweiten Parameter bezogene Ladezustandswert $SOC_2$ für eine zweite Phase des Gebrauchs der Speicherbatterie zur Bestimmung der aktuell verfügbaren Ladungsmenge erkennen, in der beispielsweise eine Säureschichtung vorliegt.

Unter Umständen kann es ausreichend sein, nur die noch entnehmbare Ladungsmenge im aktuellen Zustand der Speicherbatterie ($SOC_1$, $SOC_2$) zu ermitteln und nicht den auf die vollgeladene Speicherbatterie bezogenen Speicherfähigkeitswert CSC. Wenn der auf den ersten Parameter bezogene Ladezustandswert $SOC_1$ aus der Ruhespannung $U_{00}$ ermittelt wird und der auf den zweiten Parameter bezogene Ladezustandswert $SOC_2$ aus dem Ladungsdurchsatz Q, ist es z.B. ein Problem einen genauen Wert für den auf den zweiten Parameter bezogene Ladezustandswert $SOC_2$ zu bekommen, da durch Integrationsfehler mit fortlaufender Zeit der Wert für den Ladungsdurchsatz ungenauer wird.

In diesem Falle ist es dann zwar immer noch sinnvoll, den funktionalen Zusammenhang f'' aufzunehmen. Dann sollte jedoch die entnehmbare Ladungsmenge vom aktuellen Zustand ausgehend berechnet werden. Das ist möglich, wenn der funktionale Zusammenhang f" vergleichsweise zeitnah zu dem Vorhersagezeitpunkt aufgenommen wurde und die Steigung des funktionalen Zusammenhangs f" bekannt ist. In diesem Fall wird der auf den zweiten Parameter bezogene Ladezustandswert $SOC''_2$ aus dem funktionalen Zusammenhang f" für $SOC_1$ =0 ermittelt. Aus der Differenz zwischen dem auf dem zweiten Parameter bezogenen aktuellen Ladezustandswert $SOC_{2A}$ und dem ermittelten Ladezustandswert $SOC''_2$ und Multiplikation der Differenz mit der Batteriekapazität wird die noch entnehmbare Ladungsmenge bestimmt.

Damit können auch Ungenauigkeiten, z. B. durch Messfehler ausgeglichen werden.

## Patentansprüche

1. Verfahren zur Vorhersage von elektrischen Eigenschaften einer elektrochemischen Speicherbatterie, **gekennzeichnet durch** die Schritte:

   - Bestimmen des funktionalen Zusammenhangs (f") als Zustandskenngrößenverlauf, der die Abhängigkeit zwischen anhand der Spannung der Speicherbatterie berechneten ersten Ladezustandswertes ($SOC_1$) für eine zweite Phase des Gebrauchs der Speicherbatterie und anhand des Ladungsdurchsatzes (Q) der Speicherbatterie berechneten zweiten Ladezustandswertes ($SOC_2$) für die zweite Phase des Gebrauchs der Speicherbatterie beschreibt;
   - Ermitteln von mindestens einer Kenngröße (G) aus dem Bezug des funktionalen Zusammenhangs (f") für die zweite Phase zu einem entsprechend funktionalen Zusammenhang (f') für eine frühere erste Phase des Gebrauchs der Speicherbatterie; und
   - Vorhersage der elektrischen Eigenschaften der Speicherbatterie mit Hilfe eines funktionalen Zusammenhangs der Kenngröße (G) mit den elektrischen Eigenschaften.

2. Verfahren nach Anspruch 1, **gekennzeichnet durch** Bestimmen eines Zustandskenngrößenverlaufs (f') für die erste Phase als funktionaler Zusammenhang zwischen dem auf die Spannung der Speicherbatterie bezogenen Ladezustandswert ($SOC_1$) und dem auf den Ladungsdurchsatz der Speicherbatterie bezogenen Ladezustandswert ($SOC_2$), wobei die Änderung des Zustandskenngrößenverlaufs von der ersten Phase zur zweiten Phase ein Maß für den Zustand des Elektrolyts der Speicherbatterie ist.

3. Verfahren nach Anspruch 2, **gekennzeichnet durch** Bestimmen der Säurekapazität ($Q_0$), des Wasserverlustes (WL) und/oder der Säureschichtung des Elektrolyts in Abhängigkeit von der Änderung des Zustandskenngrößenverlaufs von der ersten Phase zur zweiten Phase.

4. Verfahren nach einem der vorhergehenden Ansprüche, **dadurch gekennzeichnet, dass** der erste Ladestandswert ($SOC_1$) auf die Ruhespannung ($U_{00}$) der Speicherbatterie bezogen ist.

5. Verfahren nach einem der vorhergehenden Ansprüche, **gekennzeichnet durch** Bestimmen des zweiten Ladezustandswertes ($SOC_2$) **durch** Bilanzieren des zwischen einem ersten Betriebszeitpunkt und einem zweiten Betriebszeitpunkt geflossenen Stromes als umgesetzte Ladungsmenge ($\Delta Q$).

6. Verfahren nach Anspruch 5, **gekennzeichnet durch** Bestimmen jeweils einer Kenngröße (S', S") für die erste und zweite Phase aus dem Verhältnis der Änderung des auf den ersten Parameter ($U_{00}$) bezogenen Ladezustandswertes ($\Delta SOC_1$) zu der Änderung des auf dem zweiten Parameter (Q) bezogenen Ladezustandswertes ($\Delta SOC_2$) oder der auf die während der elektrischen Belastungsphase umgesetzte Ladungsmenge ($\Delta Q$) bezogene Ruhespannungsänderung ($\Delta U_{00}$) als Differenz der Ruhespannung ($U_{00,2}$) nach der elektrischen Belastungsphase und der Ruhespannung ($U_{00,1}$) vor der elektrischen Belastungsphase nach der Formel

$$S' = \frac{\Delta SOC'_1}{\Delta SOC'_2} = \frac{U'_{00,2} - U'_{00,1}}{\Delta Q'} \text{ bzw. } S'' = \frac{\Delta SOC''_1}{\Delta SOC''_2} = \frac{U''_{00,2} - U''_{00,1}}{\Delta Q''}$$

   und Ermitteln des Zustands der Speicherbatterie aus der Änderung der Kenngröße S von der ersten Phase in die zweite Phase

7. Verfahren nach Anspruch 6, **gekennzeichnet durch** Bestimmen der Säurekapazität ($Q_0$) der Speicherbatterie für die erste Phase in Abhängigkeit von der Kenngröße S, wobei sich die Säurekapazität ($Q_0$) umgekehrt proportional zur der Kenngröße S verhält.

8. Verfahren nach einem der vorhergehenden Ansprüche, **gekennzeichnet durch** Messen der Ruhespannung ($U_{00}$) im unbelasteten Zustand der Speicherbatterie nach einer Ruhephase.

9. Verfahren nach einem der vorhergehenden Ansprüche, **gekennzeichnet durch** Berechnen der Ruhespannung ($U_{00}$) aus dem zeitlichen Verlauf der Batterieklemmenspannung während einer annähernd unbelasteten Phase.

10. Verfahren nach einem der vorhergehenden Ansprüche, **gekennzeichnet durch** Berechnen der Ruhespannung ($U_{00}$) aus dem Spannungs- und Stromverlauf während des Gebrauchs der Speicherbatterie.

11. Verfahren nach einem der vorhergehenden Ansprüche, **gekennzeichnet durch** Berechnen eines aktuellen auf die Säurekapazität ($Q_0$) des Elektrolyten bezogenen relativen Ladezustandswertes ($SOC_{1',rel}$) für die erste Phase aus der aktuellen unbelasteten Spannung ($U_0$) nach der Formel

$$SOC_{1',rel} = \frac{U_0}{a} - b$$

wobei a und b konstante Größen sind.

12. Verfahren nach Anspruch 11, **gekennzeichnet durch** Berechnen eines aktuellen auf die Säurekapazität ($Q_0$) des Elektrolyten bezogenen absoluten Ladezustands für die erste Phase nach der Formel

$$SOC_{1',abs} = SOC_{1',rel} \cdot Q_0$$

13. Verfahren nach einem der vorhergehenden Ansprüche, **gekennzeichnet durch** Berechnen eines aktuellen auf die Säurekapazität ($Q_0$) des Elektrolyten bezogenen relativen Ladezustandswertes ($SOC_{1'',rel}$) für die zweite Phase aus der aktuellen unbelasteten Spannung ($U_0$) nach der Formel

$$SOC_{1'',rel} = \frac{S'}{S''} \cdot \left(\frac{U_0}{a} - b\right),$$

wobei a und b konstante Größen sind und S' die Kenngröße für die erste Phase und S" die Kenngröße für die zweite Phase der auf die während einer elektrischen Belastungsphase umgesetzten Ladungsmenge ($\Delta Q$) bezogenen Ruhespannungsänderung ($\Delta U_{00}$) ist.

14. Verfahren nach Anspruch 13, **gekennzeichnet durch** Berechnen eines aktuellen auf die Säurekapazität ($Q_0$) bezogenen absoluten Ladezustandswertes ($SOC_{1'',abs}$), für die zweite Phase nach der Formel

$$SOC_{1'',abs} = SOC_{1'',rel} \cdot Q_0.$$

15. Verfahren nach einem der vorhergehenden Ansprüche, **gekennzeichnet durch** Bestimmen einer Maßzahl für den Verschleiß der Speicherbatterie in der zweiten Phase aus den Kenngrößen S' für die erste Phase und S" für die zweite Phase vorzugsweise nach dem Verhältnis $\frac{S''}{S'}$ oder als relative Veränderung $\frac{(S'' - S')}{S'}$.

16. Verfahren nach einem der vorhergehenden Ansprüche, **gekennzeichnet durch** Bestimmen des Endes der ersten Phase **durch** Integrieren des Betrags des Ladungsdurchsatzes, wobei die erste Phase beendet wird, wenn der integrierte Ladungsdurchsatz einen festgelegten Mindestwert überschreitet.

**17.** Verfahren nach Anspruch 16, **dadurch gekennzeichnet, dass** bei der Integration des Ladungsdurchsatzes nur solche Beiträge berücksichtigt werden, bei denen die Veränderungen des Ladezustandswertes (SOC) jeweils einen festgelegten Mindestwert überschreiten.

**18.** Verfahren nach einem der vorhergehenden Ansprüche, **gekennzeichnet durch** Bestimmen des Endes der ersten Phase in Abhängigkeit einer festgelegten Mindestzeit nach Erstinbetriebnahme der Speicherbatterie oder einer festgelegten Mindestbetriebsdauer.

**19.** Verfahren nach einem der vorhergehenden Ansprüche, **gekennzeichnet durch** Bestimmen des Endes der ersten Phase, wenn eine Säureschichtung erkannt wurde.

**20.** Verfahren nach einem der vorhergehenden Ansprüche, **gekennzeichnet durch** Bestimmen der Speicherfähigkeit (CSC) der Speicherbatterie **durch** einen funktionalen Zusammenhang zwischen der charakteristischen Kenngröße (G) und der Speicherfähigkeit (CSC).

**21.** Verfahren nach einem der vorhergehenden Ansprüche **dadurch gekennzeichnet, dass** die Bestimmung der Speicherfähigkeit durch folgende Schritte erfolgt:

- Extrapolation des Zustandskenngrößenverlaufs (f') für die erste Phase und des funktionalen Zusammenhangs (f'') für die zweite Phase in definierten Punkten oder Abschnitten auf den Nullwert des auf die Spannung der Speicherbatterie bezogenen Ladezustandswertes ($SOC_1$);
- Bestimmen der auf den Ladungsdurchsatz bezogenen Ladezustandswerte für die erste Phase ($SOC'_2$) und für die zweite Phase ($SOC''_2$) mit Hilfe des Zustandskenngrößenverlaufs (f') für die erste Phase und des funktionalen Zusammenhangs (f'') für die zweite Phase bei einem auf die Spannung bezogenen Ladezustandswert ($SOC_1$) gleich Null;
- Bestimmung einer auf den Ladungsdurchsatz bezogenen charakteristischen Kenngröße ($G_1$) aus der Differenz zwischen dem auf den Ladungsdurchsatz bezogenen Ladezustandswert ($SOC'_2$) für die erste Phase und dem auf den Ladungsdurchsatz bezogenen Ladezustandswert ($SOC''_2$) für die zweite Phase;
- Bestimmung eines auf die Spannung bezogenen Ladezustandswertes ($SOC'_1$) für die erste Phase und eines auf die Spannung bezogenen Ladezustandswertes ($SOC''_1$) für die zweite Phase aus dem Zustandskenngrößenverlauf (f') und dem funktionalen Zusammenhang (f") mit einem auf den Ladungsdurchsatz bezogenen Ladezustandswert ($SOC_2$) gleich Null;
- Bestimmung einer auf den die Spannung bezogenen charakteristischen Kenngröße ($G_2$) aus der Differenz aus dem auf die Spannung bezogenen Ladezustandswert ($SOC'_1$) für die erste Phase und dem auf den die Spannung bezogenen Ladezustandswert ($SOC''_1$) für die zweite Phase;
- Bestimmung der Speicherfähigkeit (CSC) der Speicherbatterie aus dem funktionalen Zusammenhang der auf die Spannung bezogenen charakteristischen Kenngröße ($G_1$), dem auf den Ladungsdurchsatz bezogenen charakteristischen Kenngröße ($G_2$) und der Speicherfähigkeit (CSC).

**22.** Verfahren nach Anspruch 21, **dadurch gekennzeichnet, dass** die Speicherfähigkeit (CSC) nach der Formel $CSC=100-max(G_1, G_2)$ berechnet wird.

**23.** Verfahren nach Anspruch 21 oder 22, **dadurch gekennzeichnet, dass** die Extrapolation in Bereichen von größeren Ladezustandswerten ($SOC_1$) bzw. ($SOC_2$), vorzugsweise von Ladezustandswerten größer als 50 %, erfolgt.

**24.** Verfahren nach einem der vorhergehenden Ansprüche, **dadurch gekennzeichnet, dass** die entnehmbare Ladungsmenge im aktuellen Zustand ($SOC_{1A}$, $SOC_{2A}$) bestimmt wird, in dem die Differenz zwischen einem Ladezustandswert ($SOC_{2A}$) und der Kenngröße (G) als Wert des auf den Ladungsdurchsatz bezogenen Ladezustandswertes ($SOC_2$) aus dem funktionalen Zusammenhang (f") mit dem auf die Spannung bezogenen Ladezustandswert ($SOC_1$) gleich Null gebildet wird und die Differenz durch Multiplikation mit der Batteriekapazität die noch entnehmbare Ladungsmenge im aktuellen Zustand darstellt.

**25.** Verfahren nach einem der vorhergehenden Ansprüche, **dadurch gekennzeichnet, dass** zur Ermittlung einer zu erwartenden Spannungsänderung ($\Delta U$) bei einer elektrischen Belastung (i) der Speicherbatterie und einer Temperatur (T) ein Ladezustandswert ($SOC_i$) in Abhängigkeit von der charakteristischen Kenngröße (G) für den Ladezustands abhängigen Zusammenhang zwischen der Spannungsänderung ($\Delta U$) und der elektrischen Belastung (i) verwendet wird.

**26.** Verfahren nach einem der vorhergehenden Ansprüche, **gekennzeichnet durch**

- Bestimmen der Ruhespannung ($U_{00,1}$) der Speicherbatterie zu einem ersten Zeitpunkt ($t_1$) in der zweiten Phase als Maß für den Ladezustandswert ($SOC_1(t_1)$),
- Ermitteln der nach einem Ladungsdurchsatz ($\Delta Q$) zwischen dem ersten Zeitpunkt ($t_1$) und einem zweiten Zeitpunkt ($t_2$) zu erwartenden Ruhespannung ($U_{00}(t_2)$) aus dem funktionalen Zusammenhang (f')für die zweite Phase,
- Bestimmen eines Ladezustandswertes ($SOC_1$ ($t_2$)) für den zweiten Zeitpunkt ($t_2$),
- Bestimmen der zu erwartenden Spannungsänderung ($\Delta U$) aus der ermittelten zu erwartenden Ruhespannung ($U_{00,2}$), dem Ladezustandswert ($SOC_1(t_2)$) und einer Funktion des elektrischen Innenwiderstands (Ri) in Abhängigkeit von dem auf die Spannung bezogenen Ladezustandswert ($SOC_1$), und
- Ermitteln einer zu erwartenden Spannung ($U_2$) als Differenz ($U_2 = U_{00,2}$-iRi) zwischen der für den zweiten Zeitpunkt ($t_2$) erwarteten Ruhespannung ($U_{00,2}$) und dem Produkt aus Innenwiderstand (Ri) und einem angenommenen Stromwert (i).

**27.** Verfahren nach einem der vorhergehenden Ansprüche, **gekennzeichnet durch**

- Bestimmen der Ruhespannung ($U_{00,1}$) der Speicherbatterie zu einem ersten Zeitpunkt ($t_1$) in der zweiten Phase als Ladezustandswert ($SOC_1(t_1)$,
- Ermitteln der nach einem Ladungsdurchsatz ($\Delta Q$) zwischen dem ersten Zeitpunkt ($t_1$) und einem zweiten Zeitpunkt ($t_2$) zu erwartenden Ruhespannung ($U_{00}(t_2)$) aus dem funktionalen Zusammenhang (f'') für die zweite Phase,
- Bestimmen der zu erwartenden Spannungsänderung ($\Delta U$) aus der ermittelten zu erwartenden Ruhespannung ($U_{00,2}$), dem Ladezustandswert ($SOC_1(t_2)$) und einer Funktion der Spannungsdifferenz ($\Delta U$) in Abhängigkeit von dem auf die Spannung bezogenen Ladezustandswert ($SOC_1$), und
- Ermitteln einer zu erwartenden Spannung ($U_2$) als Differenz ($U_2=U_{00.2}-\Delta U$) zwischen der für den zweiten Zeitpunkt ($t_2$) erwarteten Ruhespannung ($U_{00,2}$) und der ermittelten Spannungsänderung ($\Delta U$).

## Claims

**1.** Method for prediction of electrical characteristics of an electrochemical storage battery, which is **characterized by** the following steps:

- determination of the functional relationship (f") as a state characteristic variable profile which describes the relationship between a first state of charge value ($SOC_1$), which is calculated on the basis of the voltage of the storage battery, for a second phase of use of the storage battery, and a second state of charge value ($SOC_2$), which is calculated on the basis of the charge throughput (Q) of the storage battery, for the second phase of the use of the storage battery,
- determination of at least one characteristic variable (G) from the reference of the functional relationship (f") for the second phase to a correspondingly functional relationship (f') for a previous first phase of use of the storage battery; and
- prediction of the electrical characteristics of the storage battery with the aid of a functional relationship for the characteristic variable (G) with the electrical characteristics.

**2.** Method according to Claim 1, **characterized by** determination of a state characteristic variable profile (f') for the first phase as a functional relationship between the state of charge value ($SOC_1$) which is related to the voltage of the storage battery and the state of charge value ($SOC_2$) which is related to the charge throughput of the storage battery, with the change in the state characteristic variable profile from the first phase to the second phase being a measure of the state of the electrolyte in the storage battery.

**3.** Method according to Claim 2, **characterized by** determination of the acid capacity ($Q_0$), of the water loss (WL), and/or of the acid stratification of the electrolyte as a function of the change in the state characteristic variable profile from the first phase to the second phase.

4. Method according to one of the preceding claims, **characterized in that** the first charge value ($SOC_1$) is related to the rest voltage ($U_{00}$) of the storage battery.

5. Method according to one of the preceding claims, **characterized by** determination of the second state of charge value ($SOC_2$) by balancing of the current which has flowed between a first operating time and a second operating time as the transferred amount of charge ($\Delta Q$).

6. Method according to Claim 5, **characterized by** determination of a respective characteristic variable (S', S") for the first phase and for the second phase from the ratio of the change in the state of charge value ($\Delta SOC_1$) which relates to the first parameter ($U_{00}$) to the change in the state of charge value ($\Delta SOC_2$) which relates to the second parameter (Q), or of the rest voltage change ($\Delta U_{00}$) which relates to the amount of charge ($\Delta Q$) transferred during the electrical load phase, as the difference between the rest voltage ($U_{00,2}$) after the electrical load phase and the rest voltage ($U_{00,1}$) before the electrical load phase, using the formula

$$S' = \frac{\Delta SOC_1'}{\Delta SOC_2'} = \frac{U'_{00,2} - U'_{00,1}}{\Delta Q'} \text{ and } S'' = \frac{\Delta SOC_1''}{\Delta SOC_2''} = \frac{U''_{00,2} - U''_{00,1}}{\Delta Q''}$$

and determination of the state of the storage battery from the change in the characteristic variable S from the first phase to the second phase.

7. Method according to Claim 6, **characterized by** determination of the acid capacity ($Q_0$) of the storage battery for the first phase as a function of the characteristic variable S, with the acid capacity ($Q_0$) being inversely proportional to the characteristic variable of S.

8. Method according to one of the preceding claims, **characterized by** measurement of the rest voltage ($U_{00}$) in the unloaded state of the storage battery after a rest voltage phase.

9. Method according to one of the preceding claims, **characterized by** calculation of the rest voltage ($U_{00}$) from the time profile of the battery terminal voltage during an approximately unloaded phase.

10. Method according to one of the preceding claims, **characterized by** calculation of the rest voltage ($U_{00}$) from the voltage and current profile during use of the storage battery.

11. Method according to one of the preceding claims,
**characterized by** calculation of an instantaneous relative state of charge value ($SOC_1'{}_{,rel}$), which relates to the acid capacity ($Q_0$) of the electrolyte, for the first phase from the instantaneous unloaded voltage ($U_0$) using the formula

$$SOC_1'{}_{,rel} = \frac{U_0}{a} - b$$

where a and b are constants.

12. Method according to Claim 11, **characterized by** calculation of an instantaneous absolute state of charge, which relates to the acid capacity ($Q_0$) of the electrolyte, for the first phase using the formula

$$SOC_1'{}_{,abs} = SOC_1'{}_{,rel} \cdot Q_0$$

13. Method according to one of the preceding claims, **characterized by** calculation of an instantaneous relative state of charge value ($SOC_1''{}_{,rel}$), which relates to the acid capacity ($Q_0$) of the electrolyte, for the second phase from the instantaneous unloaded voltage ($U_0$) using the formula

$$SOC_1{''}_{,rel} = \frac{S'}{S''} \cdot \left(\frac{U_0}{a} - b\right),$$

where a and b are constants, S' is the characteristic variable for the first phase, and S" is the characteristic variable for the second phase of the rest voltage change ($\Delta U_{00}$) which relates to the amount of charge ($\Delta Q$) transferred during an electrical load phase.

**14.** Method according to Claim 13, **characterized by** calculation of an instantaneous absolute state of charge value ($SOC_1{''}_{,abs}$), which relates to the acid capacity ($Q_0$), for the second phase using the formula

$$SOC_1{''}_{,abs} = SOC_1{''}_{,rel} . Q_0 .$$

**15.** Method according to one of the preceding claims, **characterized by** determination of a measure for the wear of the storage battery in the second phase from the characteristic variables S' for the first phase and S" for the second phase, preferably based on the ratio $\frac{S''}{S'}$ or as the relative change $\frac{(S'' - S')}{S'}$ .

**16.** Method according to one of the preceding claims, **characterized by** determination of the end of the first phase by integration of the amount of charge throughput, with the first phase being ended when the integrated charge throughput exceeds a fixed minimum value.

**17.** Method according to Claim 16, **characterized in that** the only contributions which are taken into account for the integration of the charge throughput are those for which the changes in the state of charge value (SOC) in each case exceed a fixed minimum value.

**18.** Method according to one of the preceding claims, **characterized by** determination of the end of the first phase as a function of a fixed minimum time after initial use of the storage battery, or a fixed minimum operating period.

**19.** Method according to one of the preceding claims **characterized by** determination of the end of the first phase when acid stratification has been identified.

**20.** Method according to one of the preceding claims, **characterized by** determination of the storage capability (CSC) of the storage battery by means of a functional relationship between the characteristic variable (G) and the storage capability (CSC).

**21.** Method according to one of the preceding claims, **characterized in that** the storage capability is determined by the following steps:

- extrapolation of the state characteristic variable profile (f') for the first phase and of the functional relationship (f") for the second phase at defined points or in defined sections to the zero value of the state of charge value ($SOC_1$) which relates to the voltage of the storage parameter;
- determination of the state of charge values which relate to the charge throughput for the first phase ($SOC'_2$) and for the second phase ($SOC''_2$) with the aid of the state characteristic variable profile (f') for the first phase, and of the functional relationship (f") for the second phase for a state of charge value ($SOC_1$) which relates to the voltage and is equal to zero;
- determination of a characteristic variable ($G_1$) which relates to the charge throughput from the difference between the state of charge value ($SOC'_2$) which relates to the charge throughput for the first phase, and the state of charge value ($SOC''_2$) which relates to the charge throughput for the second phase;
- determination of a state of charge value ($SOC'_1$) which relates to the voltage for the first phase and a state of charge value ($SOC''_1$) which relates to the voltage for the second phase from the state characteristic variable profile (f') and from the functional relationship (f") with a state of charge value ($SOC_2$) which relates to the charge throughput and is equal to zero;

- determination of a characteristic variable ($G_2$) which relates to the voltage from the difference between the state of charge value ($SOC'_1$) which relates to the voltage for the first phase, and the state of charge value ($SOC''_1$) which relates to the voltage for the second phase;
- determination of the storage capability (CSC) of the storage battery from the functional relationship between the characteristic variable ($G_1$) which relates to the voltage, the characteristic variable ($G_2$) which relates to the charge throughput, and the storage capability (CSC).

**22.** Method according to Claim 21, **characterized in that** the storage capability (CSC) is calculated using the formula CSC=100-max ($G_1$, $G_2$) .

**23.** Method according to Claim 21 or 22, **characterized in that** the extrapolation is carried out in areas of greater state of charge values ($SOC_1$) and ($SOC_2$), preferably of state of charge values greater than 50%.

**24.** Method according to one of the preceding claims, **characterized in that** the amount of charge which can be drawn in the instantaneous state ($SOC_{1A}$, $SOC_{2A}$) is determined by forming the difference between a state of charge value ($SOC_{2A}$) and the characteristic variable (G) as the value of the state of charge value ($SOC_2$) which is related to the charge throughput from the functional relationship (f") with the state of charge value ($SOC_1$) which is related to the voltage and is equal to zero, and with the difference multiplied by the battery capacity representing the amount of charge which can still be drawn in the instantaneous state.

**25.** Method according to one of the preceding claims, **characterized in that** a state of charge value ($SOC_i$) is used to determine a voltage change ($\Delta U$) to be expected when an electrical load (i) is applied to the storage battery at a temperature (T), as a function of the relationship, which is dependent on the characteristic variable (G) for the state of charge, between the voltage change ($\Delta U$) and the electrical load (i).

**26.** Method according to one of the preceding claims, **characterized by:**

- determination of the rest voltage ($U_{00,1}$) of the storage battery at a first time ($t_1$) in the second phase as a measure of the state of charge value ($SOC_1(t_1)$),
- determination of the rest voltage ($U_{00}(t_2)$) to be expected between the first time ($t_1$) and a second time ($t_2$) after a charge throughput ($\Delta Q$), from the functional relationship (f") for the second phase,
- determination of a state of charge value ($SOC_1(t_2)$) for the second time ($t_2$),
- determination of the voltage change ($\Delta U$) to be expected from the determined rest voltage ($U_{00,2}$) to be expected, the state of charge value ($SOC_1(t_2)$) and a function of the electrical internal resistance (Ri) as a function of the state of charge value ($SOC_1$) which is related to the voltage, and
- determination of a voltage ($U_2$) to be expected as the difference ($U_2=U_{00,2}$-iRi) between the rest voltage ($U_{00,2}$) expected for the second time ($t_2$) and the product of the internal resistance (Ri) and an assumed current value (i).

**27.** Method according to one of the preceding claims, **characterized by**

- determination of the rest voltage ($U_{00,1}$) of the storage battery at a first time ($t_1$) in the second phase as the state of charge value ($SOC_1(t_1)$),
- determination of the rest voltage ($U_{00}(t_2)$) to be expected between the first time ($t_1$) and a second time ($t_2$) after a charge throughput ($\Delta Q$), from the functional relationship (f") for the second phase,
- determination of the voltage change ($\Delta U$) to be expected from the determined rest voltage ($U_{00,2}$) to be expected, the state of charge value ($SOC_1(t_2)$) and a function of the voltage difference ($\Delta U$), as a function of the state of charge value ($SOC_1$) which is related to the voltage, and
- determination of a voltage ($U_2$) to be expected as the difference ($U_2=U_{00,2}-\Delta U$) between the rest voltage ($U_{00,2}$) expected at the second time ($t_2$) and the determined voltage change ($\Delta U$).

## Revendications

**1.** - Procédé pour la prédiction des caractéristiques électriques d'une batterie de stockage électrochimique, **caractérisé par** les étapes suivantes :

- détermination de la relation fonctionnelle (f") pour l'évolution de la grandeur d'état caractéristique, qui décrit la dépendance entre la première valeur de l'état de la charge ($S0C_1$) calculée à partir de la tension de la batterie de stockage pour une deuxième phase d'utilisation de la batterie de stockage et une deuxième valeur de l'état de la charge ($S0C_2$) calculée à partir de la capacité de charge (Q) de la batterie de stockage pour la deuxième phase d'utilisation de la batterie de stockage ;
- détermination d'au moins une grandeur caractéristique (G) à partir du rapport de la relation fonctionnelle (f") pour la deuxième phase sur une relation fonctionnelle (f') correspondante pour une précédente première phase d'utilisation de la batterie de stockage ; et
- prédiction des caractéristiques électriques de la batterie de stockage au moyen d'une relation fonctionnelle de la grandeur caractéristique (G) avec les caractéristiques électriques.

**2.** - Procédé selon la revendication 1, **caractérisé par** la détermination de l'évolution de la grandeur d'état caractéristiques (f') pour la première phase en tant que relation fonctionnelle entre la valeur d'état de charge ($S0C_1$) déduite de la tension de la batterie de stockage et la valeur d'état de charge ($S0C_2$) déduite de la capacité de charge de la batterie de stockage, la variation de l'évolution de la grandeur d'état caractéristique de la première phase à la deuxième phase étant une mesure de l'état de l'électrolyte de la batterie de stockage.

**3.** - Procédé selon la revendication 2, **caractérisé par** la détermination de la capacité d'acide ($Q_0$), de la perte d'eau (WL) et de la concentration en acide de l'électrolyte en fonction de la variation de l'évolution de la grandeur d'état caractéristique de la première phase à la deuxième phase.

**4.** - Procédé selon l'une des revendications précédentes **caractérisé en ce que** la première valeur d'état de charge ($S0C_1$) est déduite de la tension au repos ($U_{00}$) de la batterie de stockage.

**5.** - Procédé selon l'une des revendications précédentes **caractérisé par** la détermination de la deuxième valeur d'état de charge ($S0C_2$) en faisant le bilan du courant qui s'est écoulé, en tant que quantité de charge ($\Delta Q$) transformée entre un premier point de fonctionnement et un second point de fonctionnement.

**6.** - Procédé selon la revendication 5, **caractérisé par** la détermination à chaque fois d'une grandeur caractéristique (S', S") pour la première et la deuxième phase à partir du rapport de la variation de la valeur d'état de charge ($\Delta S0C_1$) déduite du premier paramètre ($U_{00}$) sur la variation de la valeur d'état de charge ($\Delta S0C_2$) déduite du second paramètre (Q) ou bien de la variation de la tension de repos ($\Delta U_{00}$) déduite de la quantité de charge transformée ($\Delta Q$) pendant la phase de consommation électrique en tant que différence de la tension de repos ($U_{00,2}$) après la phase de consommation électrique et de la tension de repos ($U_{00,1}$) avant la phase de consommation électrique selon la formule

$$S' = \frac{\Delta SOC'_1}{\Delta SOC'_2} = \frac{U'_{00,2} - U'_{00,1}}{\Delta Q'} ou S'' = \frac{\Delta SOC''_1}{\Delta SOC''_2} = \frac{U''_{00,2} - U''_{00,1}}{\Delta Q''}$$

et détermination de l'état de la batterie de stockage à partir de la variation de la grandeur caractéristique (S) de la première phase à la deuxième phase.

**7.** - Procédé selon la revendication 6, **caractérisé par** la détermination de la capacité d'acide (Qo) de la batterie de stockage pour la grandeur caractéristique S, la capacité d'acide (Qo) restant inversement proportionnelle à la grandeur S.

**8.** - procédé selon l'une des revendications précédentes, **caractérisé par** la mesure de la tension de repos ($U_{00}$) lorsque la batterie de stockage n'est pas sollicitée après une phase de repos.

**9.** - Procédé selon l'une des revendications précédentes, **caractérisé par** le calcul de la tension de repos ($U_{00}$) à partir de l'évolution temporelle de la tension aux bornes de la batterie pendant une phase sensiblement non sollicitée.

**10.** - Procédé selon l'une des revendications précédentes, **caractérisé par** le calcul de la tension de repos ($U_{00}$) à partir de l'évolution de la tension et du courant pendant l'utilisation de la batterie.

**11.** - Procédé selon l'une des revendications précédentes, **caractérisé par** le calcul d'une valeur actuelle relative de l'état de charge ($SOC_{1',rel}$) déduite de la capacité d'acide (Qo) de l'électrolyte pour la première phase à partir de la tension actuelle (Uo) à l'état non sollicité selon la formule

$$SOC'_{1,rel} = \frac{U_0}{a} - b$$

dans laquelle a et b sont des valeurs constantes.

**12.** - Procédé selon la revendication 11, **caractérisé par** le calcul d'un état de charge actuel absolu déduit de la capacité d'acide (Qo) de l'électrolyte pour la première phase selon la formule

$$SOC'_{1,abs} = SOC'_{1\,rel} . Q_0$$

**13.** - Procédé selon l'une des revendications précédentes, **caractérisé par** le calcul d'une valeur actuelle relative d'état de charge ($SOC_1$",rel) déduite de la capacité d'acide (Qo) de l'électrolyte, pour la deuxième phase à partir de la tension (Uo) actuelle à l'état non sollicité selon la formule

$$SOC_1{}''_{,rel} = \frac{S'}{S''}\left(\frac{U_0}{a} - b\right)$$

dans laquelle a et b sont des valeurs constantes et S' est la grandeur caractéristique pour la première phase, S" la grandeur caractéristique pour la deuxième phase qui sont déduites de la variation de la tension de repos ($\Delta U_{00}$) pendant une phase de sollicitation électrique dans laquelle une quantité de charge ($\Delta Q$) est transformée.

**14.** - Procédé selon la revendication 13, **caractérisé par** le calcul d'une valeur actuelle absolue d'état de charge (SOC"$_1$, abs) déduite de la capacité d'acide (Qo) pour la deuxième phase selon la formule

$$SOC''_{1,abs} = SOC''_{1,rel} . Q_{0.}$$

**15.** - Procédé selon l'une des revendications précédentes, **caractérisé par** la détermination d'un nombre de mesure pour l'usure de la batterie de stockage dans la deuxième phase à partir des grandeurs caractéristiques S' pour la première phase et S" pour la deuxième phase de préférence selon le rapport $\frac{S''}{S'}$ ou en tant de variation relative

**16.** - Procédé selon l'une des revendications précédentes, **caractérisé par** la détermination de la fin de la première phase par intégration de la somme des capacités de charge, la première phase étant terminée, lorsque la capacité de charge intégrée dépasse une valeur minimale déterminée.

**17.** - Procédé selon la revendication 16, **caractérisé en ce que** lors de l'intégration de la capacité de charge, on ne tient compte que des valeurs pour lesquelles les variations des valeurs d'état de charge (S0C) dépassent chaque fois une valeur minimale déterminée.

**18.** - Procédé selon l'une des revendications précédentes, **caractérisé par** la détermination de la fin de la première phase en fonction d'une durée minimale déterminée après une première mise en service de la batterie de stockage ou après une durée minimale de service.

**19.** - Procédé selon l'une des revendications précédentes, **caractérisé par** la détermination de la fin de la première phase, lorsqu'un dépôt d'acide est identifié.

**20.** - Procédé selon l'une des revendications précédentes, **caractérisé par** la détermination de la capacité de stockage (CSC) de la batterie de stockage à partir d'une relation fonctionnelle entre les grandeurs caractéristiques (G) et la capacité de stockage (CSC).

**21.** - procédé selon l'une des revendications précédentes, **caractérisé en ce que** la détermination de la capacité de stockage est effectuée selon les étapes suivantes :

- extrapolation de l'évolution des grandeurs d'état caractéristique (f') pour la première phase et des relations fonctionnelles (f") pour la deuxième phase en des points définis ou des segments sur la valeur nulle de la valeur d'état de chaque ($SOC_1$) déduite de la tension de la batterie de stockage ;
- détermination de la valeur d'état de charge déduite de la capacité de charge pour la première phase ($SOC'_2$) et pour la deuxième phase ($SOC''_2$) au moyen de l'évolution de la grandeur d'état (f') pour la première phase et la relation fonctionnelle (f") pour la deuxième phase en cas d'une valeur d'état de charge ($SOC_1$) déduite de la tension égale à O ;
- détermination d'une grandeur caractéristique ($G_1$) déduite de la capacité de charge à partir de la différence entre de la valeur d'état de charge ($SOC'_2$) déduite de la capacité de charge pour la première phase et de la valeur d'état de charge ($SOC''_2$) déduite de la capacité de charge pour la deuxième phase,
- détermination d'une valeur d'état de charge ($SOC'_1$) déduite de la tension pour la première phase et d'une valeur d'état de charge ($SOC''_1$) déduite de la tension pour la deuxième phase à partir de l'évolution de la grandeur d'état caractéristique (f') et de la relation fonctionnelle (f") avec une valeur d'état de charge ($SOC_2$) déduite de la capacité de charge égale à O ;
- détermination d'une grandeur caractéristique ($G_2$) déduite de la tension à partir de la différence de la valeur d'état de charge ($SOC'_1$) déduite de la tension pour la première phase et de la valeur d'état de charge ($SOC''_1$) déduite de la tension pour la deuxième phase ;
- détermination de la capacité de stockage (CSC) de la batterie de stockage à partir de la relation fonctionnelle de la grandeur caractéristique ($G_1$) déduite de la tension, de la grandeur caractéristique ($G_2$) déduite de la capacité de charge et de la capacité de stockage (CSC).

**22.** - Procédé selon la revendication 21, **caractérisé en ce que** la capacité de stockage (CSC) est calculée selon la formule $CSC = 100\text{-max}\,(G_1, G_2)$.

**23.** - Procédé selon la revendication 21 ou 22, **caractérisé en ce que** l'extrapolation est effectuée dans des zones de valeurs d'état de charge ($SOC_1$), ($SOC_2$) les plus grandes, de préférence de valeurs d'état de charge plus grandes que 50%.

**24.** - Procédé selon l'une des revendications précédentes, **caractérisé en ce que** la quantité de charge pouvant être prélevée dans l'état actuel ($SOC_{1A}$, $SOC_{2A}$) est déterminée, de façon que la différence entre une valeur d'état de charge ($SOC_{2A}$) et la grandeur caractéristique (G) en tant que valeur de la valeur de l'état de charge ($SOC_2$) déduite de la capacité de charge est créée à partie de la relation fonctionnelle (f") avec la valeur de l'état de charge ($SOC_1$) égale à 0 et la différence établit par multiplication avec la capacité de la batterie la quantité de charge qui peut encore être prélevée dans l'état actuel.

**25.** - Procédé selon l'une des revendications précédentes, **caractérisé en ce que** pour déterminer une variation prévisible de la tension ($\Delta U$) en cas de sollicitation électrique (i) de la batterie de stockage à une température (T), on utilise une valeur d'état de charge ($SOC_i$) en fonction de la grandeur caractéristique (G) pour la relation fonctionnelle dépendant de l'état de charge entre la variation de la tension ($\Delta U$) et la sollicitation électrique (i).

**26.** - Procédé selon l'une des revendications précédentes, **caractérisé par**

- la détermination de la tension de repos ($U_{00,1}$) de la batterie de stockage à un premier instant ($t_1$) dans la deuxième phase en tant que mesure pour la valeur de l'état de charge ($SOC_1(t_1)$),
- la détermination de la tension de repos ($U_{00}(t_2)$) prévisible après une capacité de charge ($\Delta Q$) entre le premier instant ($t_1$) et un deuxième instant ($t_2$) à partir de la relation fonctionnelle (f") pour la deuxième phase,
- la détermination d'une valeur d'état de charge ($SOC_1(t_2)$)pour le deuxième instant ($t_2$),
- la détermination de la variation de tension ($\Delta U$) prévisible à partir de la tension de repos prévisible ($U_{00,2}$) obtenue, de la valeur d'état de la charge ($SOC_1(t_2)$) et une fonction de la résistance électrique interne (Ri) en fonction de la valeur d'état de charge ($SOC_1$) déduite de la tension, et
- l'obtention d'une tension prévisible -$U_2$) en tant que différence ($U_2 = U_{00,2}$ - iRi) entre la tension de repos ($U_{00,2}$) prévisible pour le deuxième instant (t2) et le produit à partir de la résistance interne (Ri) et une valeur donnée du courant (i).

**27.** - Procédé selon l'une des revendications précédentes, **caractérisé par**

- la détermination de la tension de repos ($U_{00},_1$) de la batterie de stockage à un premier instant ($t_1$) dans la deuxième phase en tant que valeur de l'état de charge ($SOC_1(t_1)$),
- la détermination de la tension de repos ($U_{00}(t_2)$) prévisible après une capacité de charge ($\Delta Q$) entre le premier instant ($t_1$) et un deuxième instant ($t_2$) à partir de la relation fonctionnelle (f") pour la deuxième phase,
- la détermination de la variation de tension (AU) prévisible à partir de la tension de repos prévisible ($U_{00,2}$) obtenue, de la valeur d'état de la charge ($SOC_1(t_2)$) et une fonction de la différence de tension ($\Delta U$) en fonction de la valeur d'état de charge ($SOC_1$) déduite de la tension, et
- détermination d'une tension prévisible ($U_2$) en tant que différence ($U_2 = U_{00,2} - \Delta U$) entre la tension de repos ($U_{00,2}$) prévisible pour le deuxième point ($t_2$) et la variation de tension (AU) obtenue.

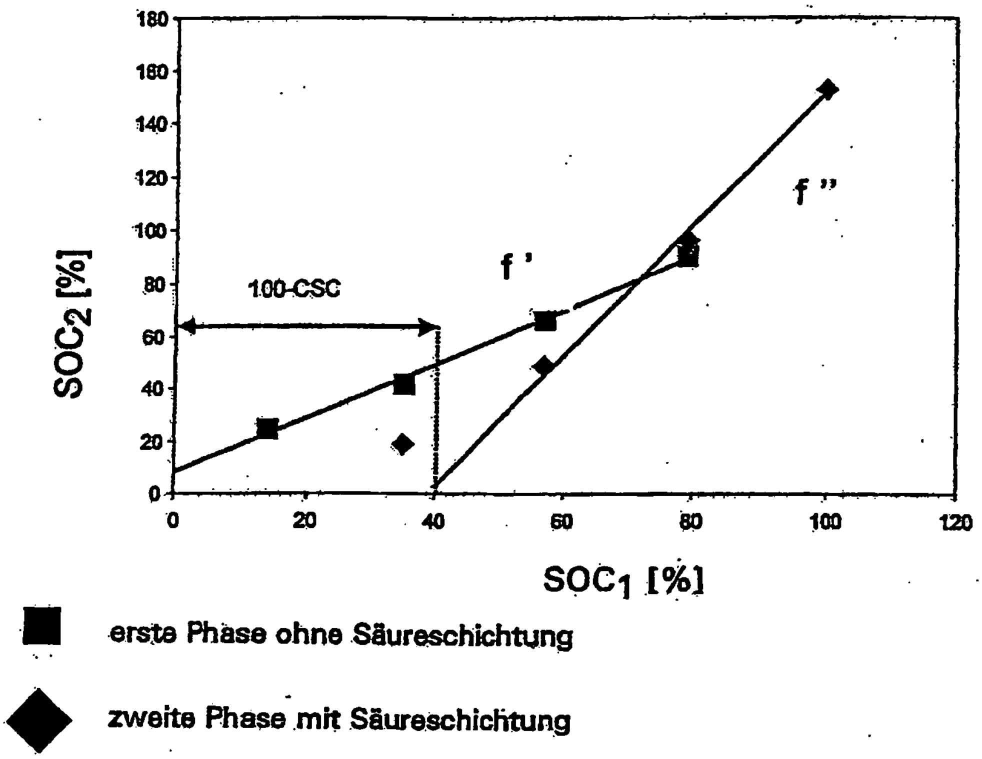
180
160
140
120
100
80
60
40
20
0
0
20
40
60
80
100
120
SOC2 [%]
SOC1 [%]
100-CSC
f '
f ''
erste Phase ohne Säureschichtung
zweite Phase mit Säureschichtung

Fig. 1

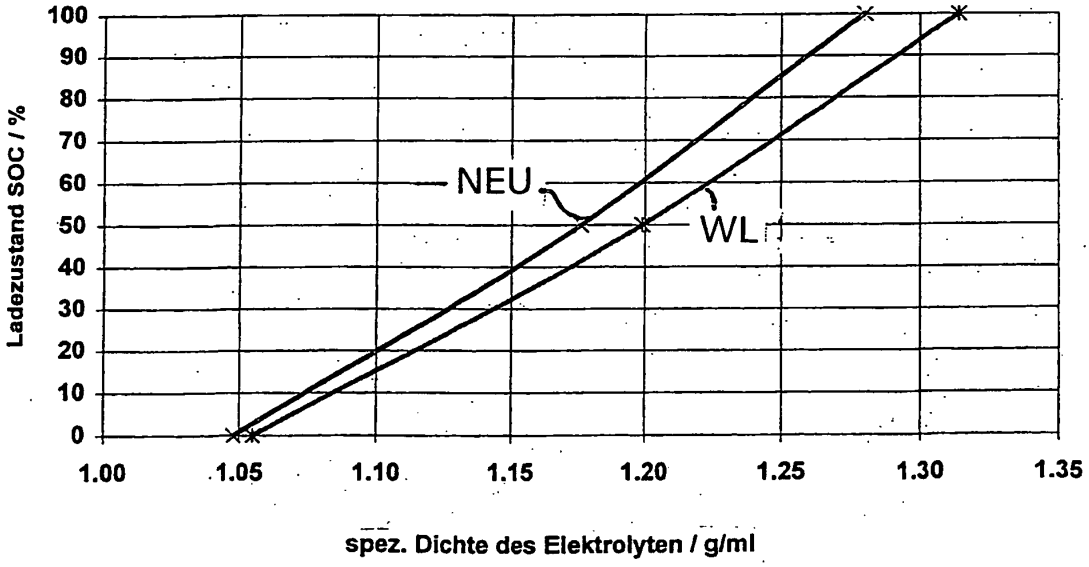
100
90
80
70
60
50
40
30
20
10
0
Ladezustand SOC / %
NEU
WL
1.00
1.05
1.10
1.15
1.20
1.25
1.30
1.35
spez. Dichte des Elektrolyten / g/ml

Fig. 2

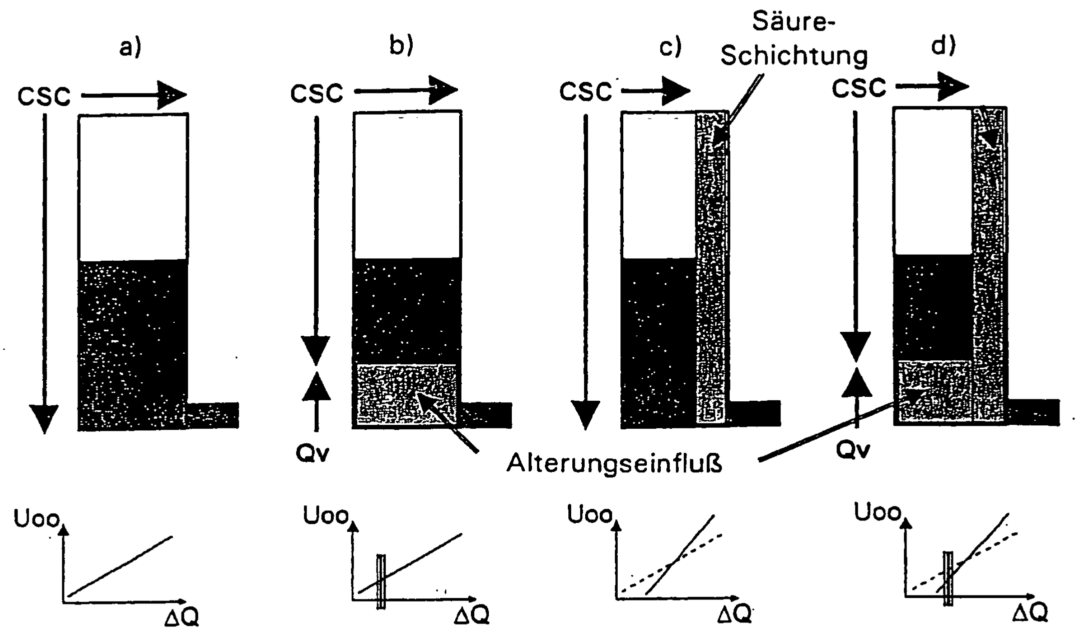
a)
b)
c)
d)
Säure-
Schichtung
CSC
Qv
Alterungseinfluß
Uoo
ΔQ

Fig. 3

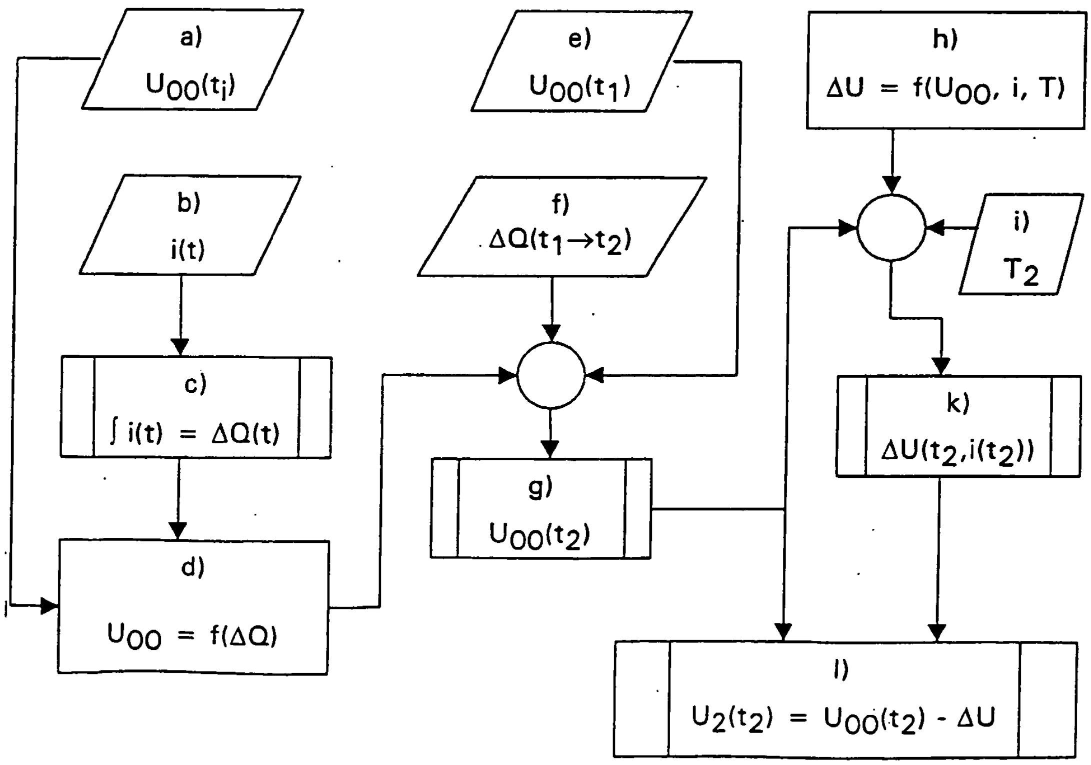
a)
U00(ti)
b)
i(t)
c)
∫ i(t) = ΔQ(t)
d)
U00 = f(ΔQ)
e)
U00(t1)
f)
ΔQ(t1→t2)
g)
U00(t2)
h)
ΔU = f(U00, i, T)
i)
T2
k)
ΔU(t2,i(t2))
l)
U2(t2) = U00(t2) - ΔU

Fig. 4

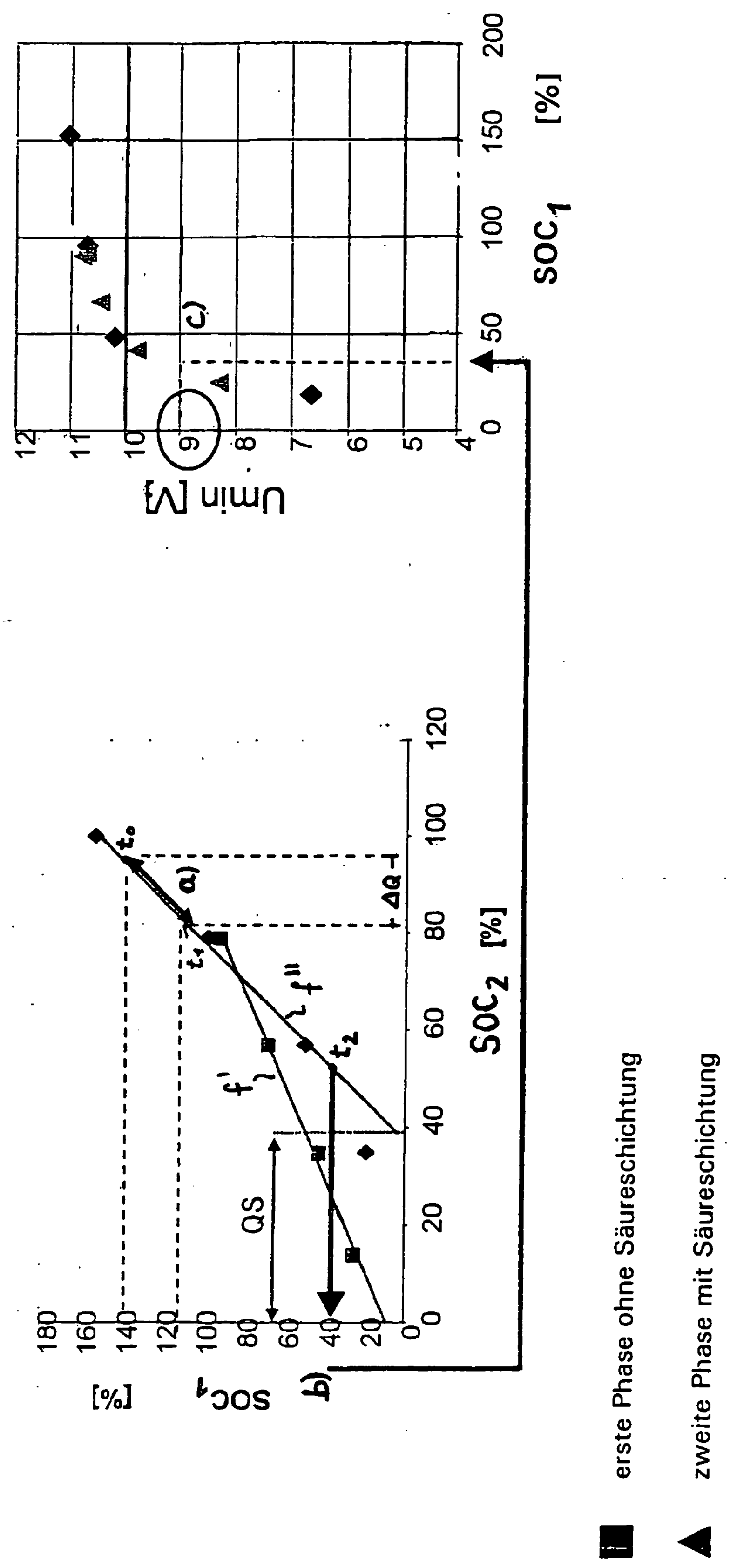

Umin [V]
12
11
10
9
8
7
6
5
4
0
50
100
150
200
$SOC_1$ [%]
c)
$SOC_1$ [%]
b)
180
160
140
120
100
80
60
40
20
0
20
40
60
80
100
120
$SOC_2$ [%]
QS
a)
ΔQ
$t_0$
$t_1$
$t_2$
f'
f''
erste Phase ohne Säureschichtung
zweite Phase mit Säureschichtung


Fig. 5

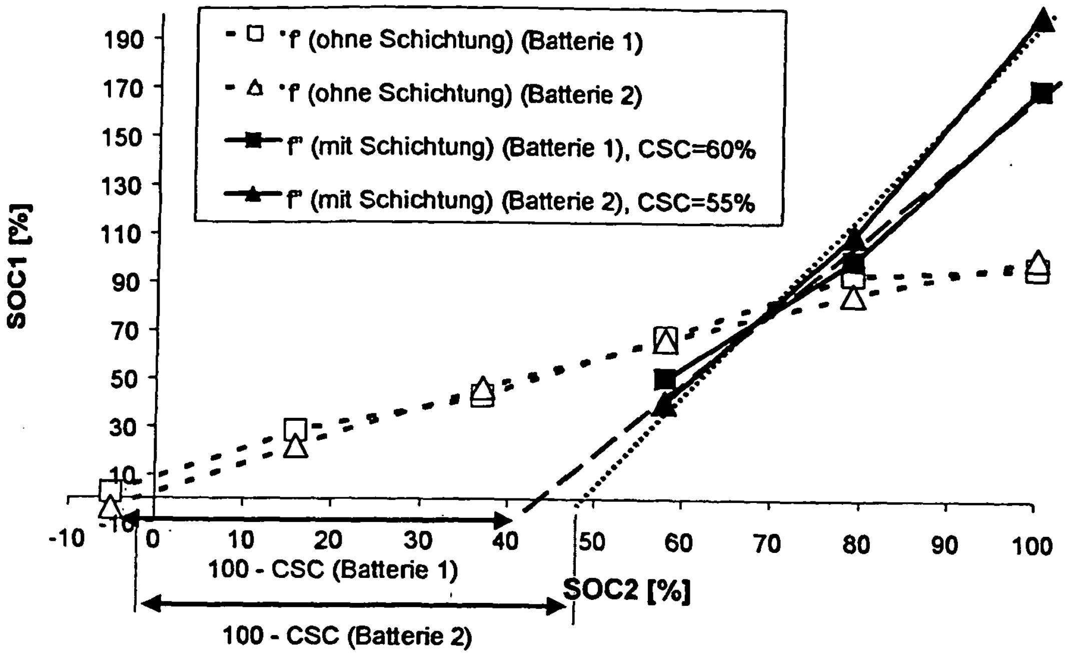

f' (ohne Schichtung) (Batterie 1)
f' (ohne Schichtung) (Batterie 2)
f'' (mit Schichtung) (Batterie 1), CSC=60%
f'' (mit Schichtung) (Batterie 2), CSC=55%
SOC1 [%]
190
170
150
130
110
90
70
50
30
10
-10
-10
0
10
20
30
40
50
60
70
80
90
100
100 - CSC (Batterie 1)
SOC2 [%]
100 - CSC (Batterie 2)


Fig. 6

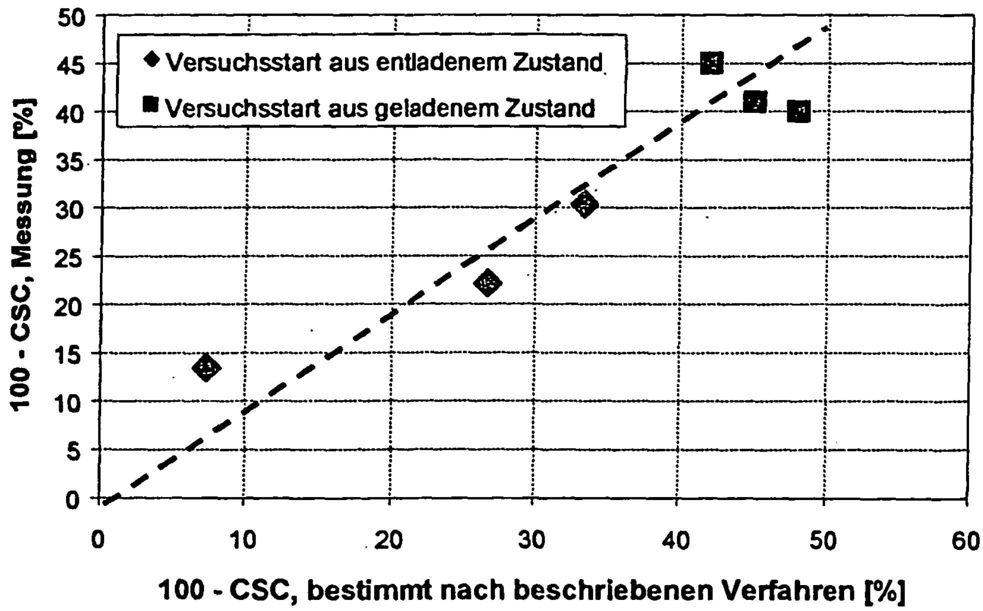

Versuchsstart aus entladenem Zustand
Versuchsstart aus geladenem Zustand
100 - CSC, Messung [%]
50
45
40
35
30
25
20
15
10
5
0
0
10
20
30
40
50
60
100 - CSC, bestimmt nach beschriebenen Verfahren [%]


Fig. 7

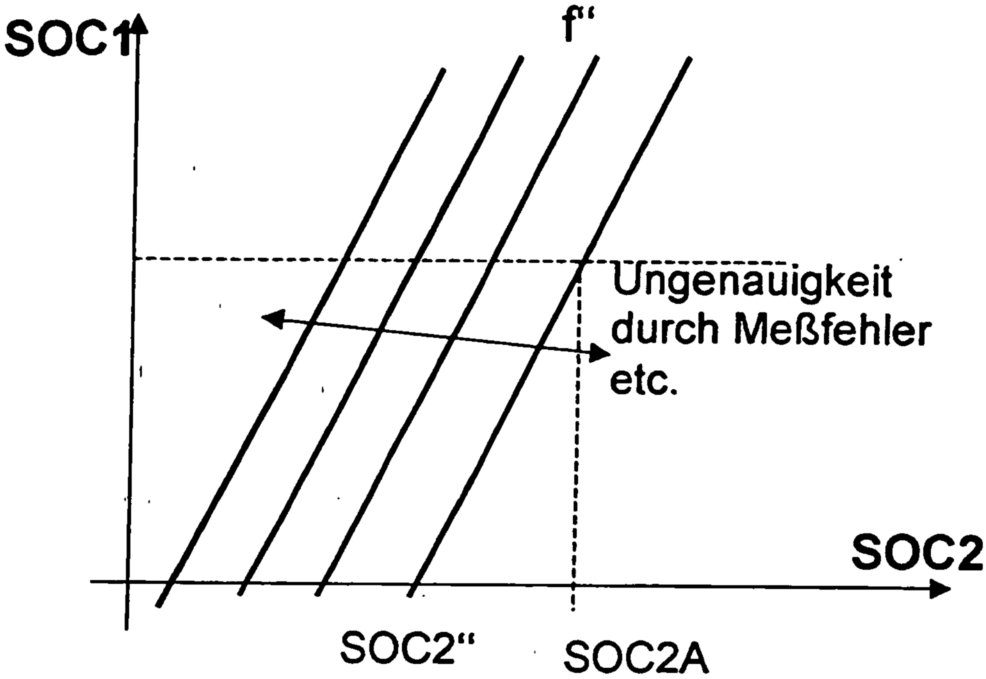


Fig. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- DE 2242510 C1
- DE 4007883 A1
- DE 19543874 A1
- DE 3901680 C1
- DE 4339568 A1
- DE 19847648 A1
- US 6268712 B1
- DE 10156891 A1
- US 5650712 A1
- EP 1120663 A